# EUROPEAN PATENT APPLICATION

(11) **EP 4 621 840 A2**
(43) Date of publication of application: **24.09.2025**
(21) Application number: 25154296.5
(22) Date of filing: 28.01.2025
(51) Int. Cl.: H01L 21/768

(54) **IC DIE FABRICATION WITH SELF-ALIGNMENT OF MULTI-LEVEL FEATURES**

(30) Priority: 18.03.2024 US 202418608682
(71) Applicant: INTEL Corporation, Santa Clara, CA 95054 (US)
(72) Inventor: ALESKOV, Aleksandar, Chandler, 85226 (US); GSTREIN, Florian, Portland, 97212 (US); KRYSAK, Marie, Portland, 97225 (US); GUZMAN, Nicole, Newberg, 97132 (US)
(74) Representative: Goddar, Heinz J.

(57) **Abstract**

Patterning features within two levels of an integrated circuit (IC) structure with a grayscale lithography process. Via and line features may be defined concurrently into a resist having a dose dependent development response using a single mask exposure comprising two or more non-zero doses. The resist may be iteratively developed two or more times and an intervening thin film etch or deposition may be practiced to transfer mask features into the IC structure. The resulting via/line in first IC interconnect level may then have no misalignment with a via/line in a second IC interconnect level within each of two orthogonal dimensions of the IC structure.

## Description

### BACKGROUND

In electronics manufacturing, the scaling of IC die features is increasingly more challenging. In lithography, the scaling of exposure wavelengths is one path in feature scaling. Another path in feature scaling is a reduction in the misalignment between features in one IC structure level with those in another (e.g., next) IC structure level. Historically, misalignment tolerance has been scaled through ever more precise alignment of a next-level feature mask to existing features of a workpiece.

Techniques of patterning features that can essentially eliminate misalignment between levels of an IC die would therefore be commercially advantageous. Similarly, IC die with features free of any misalignment between levels would also be commercial advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1A illustrates a flow diagram of methods for forming an IC with no misalignment between different feature levels, in accordance with some embodiments;
FIG. 1B, 1C and 1D illustrate schematics describing aspects of grayscale lithography, in accordance with some embodiments;
FIG. 2 illustrates a flow diagram of methods for forming an IC with no misalignment between vias and lines, in accordance with some IC die interconnect embodiments;
FIG. 3A-3C, 4A-4C, 5A-5C, 6A-6C, 7A-7C and 8A-8C illustrate plan and orthogonal cross-sectional views of an IC structure evolving as the methods illustrated in FIG. 2 are practiced in accordance with some embodiments;
FIG. 9 illustrates a flow diagram of methods for forming an IC with no misalignment between vias and lines, in accordance with some alternative IC die interconnect embodiments;
FIG. 10A-10C, 11A-11C, 12A-12C, 13A-13C, 14A-14C and 15A-15C illustrate plan and orthogonal cross-sectional views of an IC structure evolving as the methods illustrated in FIG. 9 are practiced in accordance with some embodiments;
FIG. 16 illustrates a flow diagram of methods for forming an IC with no misalignment between vias and lines, in accordance with some alternative IC die interconnect embodiments;
FIG. 17A-17C, 18A-18C, 19A-19C, 20A-20C, and 21A-21C illustrate plan and orthogonal cross-sectional views of an IC structure evolving as the methods illustrated in FIG. 16 are practiced in accordance with some embodiments;
FIG. 22 illustrates a flow diagram of methods for forming an IC with no misalignment between vias of two different levels or heights or lines of two different levels or heights, in accordance with some alternative IC die interconnect embodiments;
FIG. 23A-23C, 24A-24C, 25A-25C, and 26A-26C illustrate plan and orthogonal cross-sectional views of an IC structure evolving as the methods illustrated in FIG. 22 are practiced in accordance with some embodiments;
FIG. 27 illustrates a flow diagram of methods for forming an IC with no misalignment between vias and lines, in accordance with some subtractive patterning embodiments;
FIG. 28A-28C, 29A-29C, 30A-30C, and 31A-31C illustrate plan and orthogonal cross-sectional views of an IC structure evolving as the methods illustrated in FIG. 22 are practiced in accordance with some embodiments;
FIG. 32 illustrates a mobile computing platform or a data server machine employing a package comprising an IC die embedded within a core stack, in accordance with some embodiments; and
FIG. 33 is a functional block diagram of an electronic computing device, in accordance with some embodiments.

### DETAILED DESCRIPTION OF EXEMPLARY EMBODIMENTS

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of" or "one or more of' can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

According to embodiments described herein, features within two levels of an integrated circuit (IC) structure are patterned with grayscale lithography processes. In some exemplary embodiments, via and line features are concurrently defined into a photosensitive resist that has a dose dependent development response using a single mask exposure that imparts the resist with two or more different non-zero doses. The resist is then iteratively developed two or more times and a thin film etch or selective thin film deposition is performed between the develop iterations to transfer mask features into the IC structure.

The intervening thin film etch or deposition enables the iteratively developed mask features to be transferred into features of different IC levels (e.g., a via level and a line level) and/or into features having different vertical depths or thicknesses (e.g., shallow via and deep via or thin line and thick line). Originating from a single exposure process, the heterogeneous features transferred into different levels of an IC structure have no misalignment. For some exemplary embodiments where via and line features are concurrently exposed, a first IC interconnect feature (e.g., via) level will have no misalignment with a second IC interconnect feature (e.g., line) level within each of two orthogonal dimensions of the IC structure. With no misalignment, vias may be positioned exactly at the end of lines, enabling a reduction in line end-to-end spacing. As further described below, line features defined in accordance with embodiments herein need not be based on gratings having a single orientation relative to underlying feature levels and may instead be arbitrary polygons having one or more orientations.

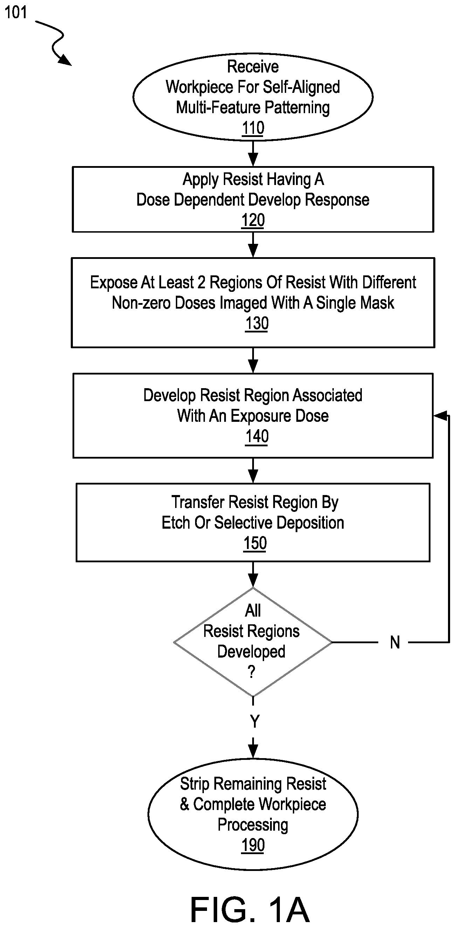

FIG. 1A illustrates a flow diagram of methods 101 for forming an IC with no misalignment between different feature levels, in accordance with embodiments herein. Methods 101 entail a grayscale photolithography process followed by iterative development of photoresist features that are successively transferred into thin film materials of the workpiece.

Methods 101 begin at input 110 with receipt of workpiece for self-aligned multi-feature patterning. The workpiece may be any known to be suitable IC fabrication. In some examples, the workpiece comprises a 300-450 mm diameter semiconductor wafer. The workpiece may comprise any number of patterned thin film feature levels. In some examples, the workpiece received at input 110 has devices (e.g., CMOS transistors) which are to be electrically interconnected into IC structures with the further fabrication of multiple levels of interconnect features. These interconnect features may comprise levels of interconnect lines extending laterally over a plane of the workpiece and levels of interconnect vias extending vertically (orthogonal to the plane of the workpiece), and which intersect lines of adj acent levels.

Methods 101 continue at block 120 where a photosensitive resist is applied over a working surface of the workpiece. The photoresist may be of any chemical composition that has a dose dependent develop response. The photoresist may also be of a composition that is photosensitive to any radiation band suitable for a particular photolithography process.

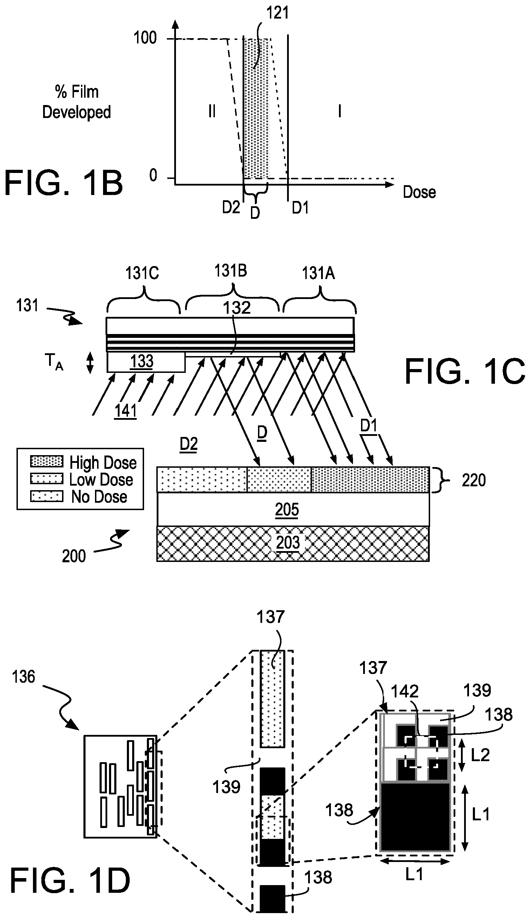

In some examples, the photoresist applied at block 120 is suitable for extreme ultraviolet lithography (EUV or EUVL) technology using a 13.5 nm center wavelength (13.3-13.7 nm band). Both positive tone and negative tone EUV resists are known and at least some of them display dose dependent development. FIG. 1B is dose-development diagram in accordance with some negative tone EUV photoresist embodiments. Although FIG. 1B may be applicable to any number of EUV photoresist compositions, the inventors have found at least some metal-oxide (MOx) resist (MOR) formulations to display the behavior illustrated in FIG. 1B.

As shown, a percentage development of a photoresist film is plotted on the y-axis as a function of exposure dose along the x-axis. Within zone I, at doses above a threshold dose (>D1), the photoresist will not develop (0%) with any develop process. Within zone II, at doses below a threshold dose (<D2), the photoresist will fully develop (100%) with any develop process. For a given resist composition, the threshold doses D1 and D2 can be modified to some extent, for example according to post-exposure bake conditions, etc.

For resists compositions with sufficient separation between threshold doses D1 and D2, there is a dose process window 121 where an intervening dose D can enable more than one non-zero exposure. Within process width 121, a dose D may render the photoresist developable by less than all the develop process that develop doses within zone II, in which case zone II is developed by a process that does not develop resist exposed to dose D. Alternatively, does D may render the photoresist developable only upon a cumulative develop comprising repetition of a process that develops doses within zone II in a single pass.

Accordingly, the photoresist need not then be limited to binary development states associated with one exposure dose and null exposure and may instead support multiple levels of development, for example further including a 50% developed state. As shown, transitions between fully developed (100%) and undeveloped states are not digital but instead have some slope dependent on process variability associated with both exposure and developer processes. The width of dose process window 121 is narrowed from the separation of threshold doses D1 and D2 by this process variability, which impacts the number of distinguishable develop levels possible for given resist composition. The illustrated width of dose process window 121 is nevertheless sufficient to introduce one additional develop level. As described further below, several IC feature patterning methods can leverage this one additional develop level. However, resists that can further support more than one intermediate dose can facilitate more elaborate grayscale patterning processes.

In some other examples, the photoresist applied at block 120 is suitable for deep ultraviolet (DUV) lithography using any of 365, 248, or 193 nm center wavelengths. Both positive tone and negative tone DUV resists are known and at least some have a dose dependent develop response sufficient to similarly support at least one intermediate development state. For example, some positive tone chemically amplified resist (CAR) compositions have been found to display a time to clear/develop that is a continuous (albeit not necessarily linear) function of the exposure dose. In a positive tone CAR, one photoevent initiates a reaction, for example through a photo-acid generator (PAG), which induces a polymer cleavage that in turns generates additional acid that can then promote further polymer cleavages in a cascade of additional chemical reactions. Such a photoresist may enable more than one intermediate dose, thereby enabling more complex grayscale patterning process and structures, for example spanning more than two levels of an IC structure.

Returning to FIG. 1A, methods 101 continue at block 130 where the photoresist is exposed to grayscale imaging with a non-binary pattern mask. As used herein, "grayscale" imaging includes irradiating a photoresist with at least two different non-zero exposure doses. In exemplary embodiments, the different exposure doses are imaged with a single mask and expose different regions of photoresist to the different non-zero doses. At block 130, imaging is with a grayscale mask having at least three intensity levels, for example corresponding to a full dose, no dose, and at least one intermediate dose. If a photoresist can support more development levels, a compatible grayscale mask may provide for a fourth intensity level, etc.

In conjunction with a multi-level resist, grayscale exposures at block 130 are employed to print at least two heterogeneous features with a single exposure operation. The features are heterogeneous in that a first of them is exposed to a first non-zero dose while a second of them is exposed to a second non-zero exposure dose. Where additional grayscale levels are supported, three or more such features may be printed at block 130.

A grayscale mask employed at block 130 may be implemented, for example as a transmissive mask or a reflective mask, according to the exposure band employed at block 130. In some exemplary embodiments where exposure doses at block 130 are within the EUV band, a reflective mask includes two or more absorbers positioned over a reflective substrate.

As shown in FIG. 1C, a reflective mask 131 including at least three zones or regions is imaged by EUV radiation 141 to irradiate a workpiece 200 that includes a substrate 203, one or more thin films 205 over substrate 203 and a photoresist 220 over thin films 205. A first mask zone 131A having highest reflectivity, directs a largest dose (>D1) to a corresponding "high dose" region of photoresist 220. A second mask zone 131B, including a first absorber 132, has lower reflectivity. Second mask zone 131B therefore directs an intermediate dose (D2<D<D1) to a corresponding "low dose" region of photoresist 220. A third mask zone 131C, including a fully extinguishing absorber 133, has null reflectivity. Third mask zone 131C therefore directs a null dose (<D2) to a corresponding a "no dose" region of photoresist 220. As described above, for exemplary negative tone resists "no dose" corresponds to a region that is always and/or rapidly developable, "high dose" corresponds to a region that is non-developable, and "low dose" is partially and/or slowly developable. For positive tone resists, "no dose" corresponds to a region that is non-developable while "high dose" is always and/or rapidly developable.

In some exemplary grayscale masks, absorbers 132 and 133 have a different absorber thickness T_{A}. For absorbers of a given composition, greater absorber thicknesses T_{A} corresponds to greater absorption. Accordingly, where absorber 133 has a minimum threshold absorber thickness T_{A} corresponding to full absorption, absorber 132 has some non-zero thickness less than that of absorber 133. If other develop levels are supported by a photoresist, mask 131 may include additional absorber thicknesses between those of absorbers 132 and 133.

Absorbers 132, 133 are applicable both to the reflective EUV mask illustrated in FIG. 1C and transmissive DUV masks. In other grayscale mask embodiments, absorber 132 may have a different material composition than absorber 133 to modulate an amount of optical phase shift induced by absorbers 132 and 133. Accordingly, absorbers 132 and 133 may comprise different phase shifting mask structures known to be suitable for binary lithography that can be further leveraged to implement grayscale lithography in according with embodiments herein.

In still other embodiments mask feature pixelation (illustrated in FIG. 1D) is practiced whereby a given mask feature is divided into pixels that have a corresponding ratio of absorber area to reflector area. The fraction of an intermediate "low" dose (D) to a full "high" dose (>D1) is then a function of the square of the ratio of reflective pixel area to total pixel area. For example, where reflective area in each pixel is 70% of a total pixel area, the low dose D will be 49% of the threshold full dose D1.

In FIG. 1D, a mask portion 136 comprises a reflective area 139, an absorber region 138 and a pixelated region 137. Assuming normal (0 deg) illumination in a patterning application where features with a 14 nm CD are to be printed on a workpiece with imaging optics having 4x reduction, a feature written on the mask to have square lengths L1 of 56 nm is printed as 14×14 nm² on the workpiece. Pixel length L2 is 28 nm for embodiments where there are two mask pixels 142 per CD. For mask pixel 142 to be grayscaled to 35% transparency, a minimum e-beam writing CD of 18 nm is needed to define absorber areas of 18 nm² within pixelated region 137. Although such dimensions may be challenging, the most advanced e-beam lithography processes used for mask writing are nearing such feature sizes. Mask writing can be made less demanding for embodiments where there is only one mask pixel per CD so that L2 is 56 nm and mask pixel 142 may then be grayscaled to 35% transparency with an absorber area of 36×26 nm². Mask writing is even less demanding for applications where workpiece feature CD can be larger than 14 nm.

Returning to FIG. 1A, methods 101 continue at block 140 where a resist feature or region associated with one exposure dose is developed. Following the first develop, the partially developed resist is employed as a mask during a thin film process performed at block 150. In some embodiments, a thin film etch process is performed at block 150 to at least partially remove a film of the workpiece exposed by the develop process. In other embodiments, a thin film deposition process is performed at block 140 to selectively form a film over a region of the workpiece exposed by the develop process. Methods 101 are then iterated through blocks 140 and 150 two or more times to define multiple, or heterogenous, features into the workpiece with no misalignment. Upon transferring the last developable resist region into the workpiece, methods 101 end at output 190 where any remaining resist is stripped and processing of the workpiece is completed according to any known techniques.

Implementations of the iterative develop and thin film processing in methods 101 may vary according to whether the photoresist is negative or positive toned. Also, depending on the implementation of methods 101, the resiliency required of photoresist regions retained after first and second develop processes may vary.

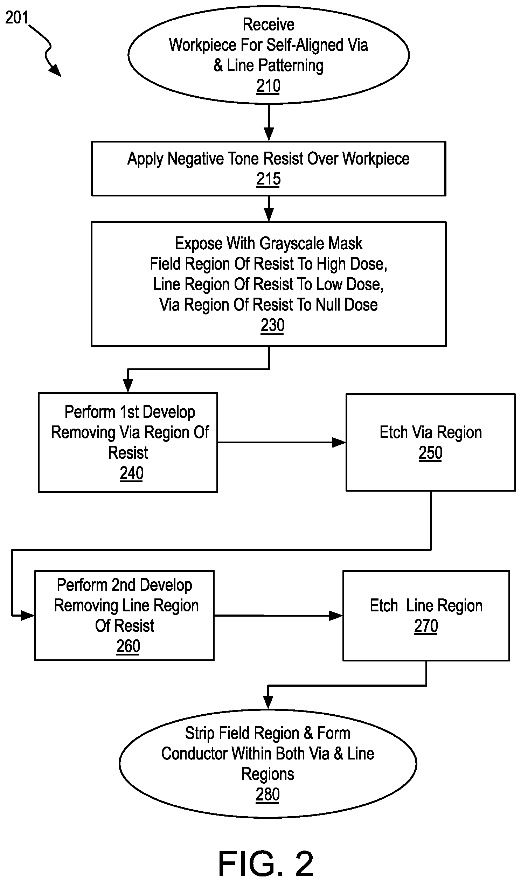

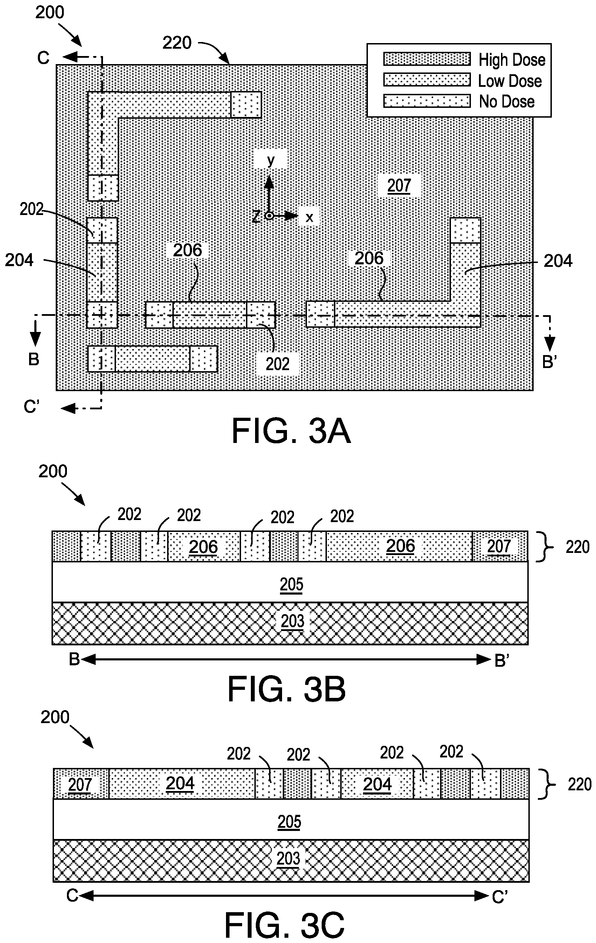

FIG. 2 illustrates a flow diagram of methods 201 for forming an IC with no misalignment between vias and lines, in accordance with some IC die interconnect embodiments. FIG. 3A-3C, 4A-4C, 5A-5C, 6A-6C, 7A-7C and 8A-8C illustrate plan and orthogonal cross-sectional views of an IC structure evolving as methods 201 are practiced in accordance with some embodiments.

Referring first to FIG. 2, methods 201 begin at input 210 is receipt of a workpiece having a dielectric thin film over a working surface. Interconnect structures comprising a level of vias below a level of lines are to fabricated into the dielectric thin film. At block 215, a negative tone resist is applied over the workpiece. The resist applied at block 215 may be any of the those described above in the context of methods 101, which have a sufficiently dose-dependent develop response to define three exposure/develop levels. At block 230, the photoresist is exposed with DUV or EUV according to a grayscale mask, such as any of those described above in the context of methods 101. At block 230, a field region of the resist is exposed to a first (high) dose, a line region of the resist is exposed to a second (low) dose, and a via region of the resist is exposed to a third (null) dose. Any suitable post-exposure bake may also be practiced at block 230 as embodiments herein are not limited in this respect.

In the example illustrated in FIG. 3A, resist 220 is over an area of a workpiece 200. Resist 220 has been exposed with a single imaging process according to a grayscale mask. Resist field regions 207 have received a high dose. Resist via regions 202 have received a null dose. Resist 220 further comprises first line regions 204 extending along a first planar dimension (e.g., y-axis) and second line regions 206 extending along a second planar dimension (e.g., x-axis). Although orthogonal line regions are illustrated, line regions 204, 206 may have any orientation within the x-y plane of resist 220. Line regions 204, 206 have received a low, but non-zero, dose.

FIG. 3B illustrates a cross-sectional view of workpiece 200 along the B-B' line illustrated in FIG. 3A. FIG. 3C illustrates a cross-sectional view of workpiece 200 along the C-C' line illustrated in FIG. 3A. As shown, resist 220 is over a workpiece thin film 205, which in exemplary embodiments comprises a dielectric material. The dielectric material may have any composition of suitable dielectric strength for the purpose of electrically isolating laterally adjacent lines or vias and/or vertically adjacent lines or vias. The dielectric material may be any material known to be suitable as an interlayer dielectric (ILD) of an IC, for example. In some embodiments, the dielectric material is a compound of silicon and/or a compound of oxygen, and/or a compound of nitrogen. Examples include silicon dioxide, silicon nitride, silicon oxynitride, and low-k materials (e.g., having a relative permittivity below 3.3). Workpiece 200 further comprises a substrate 203, which may further comprise any number of thin film layers and crystalline semiconductor device layers over a handling/support material (e.g., monocrystalline silicon, etc.).

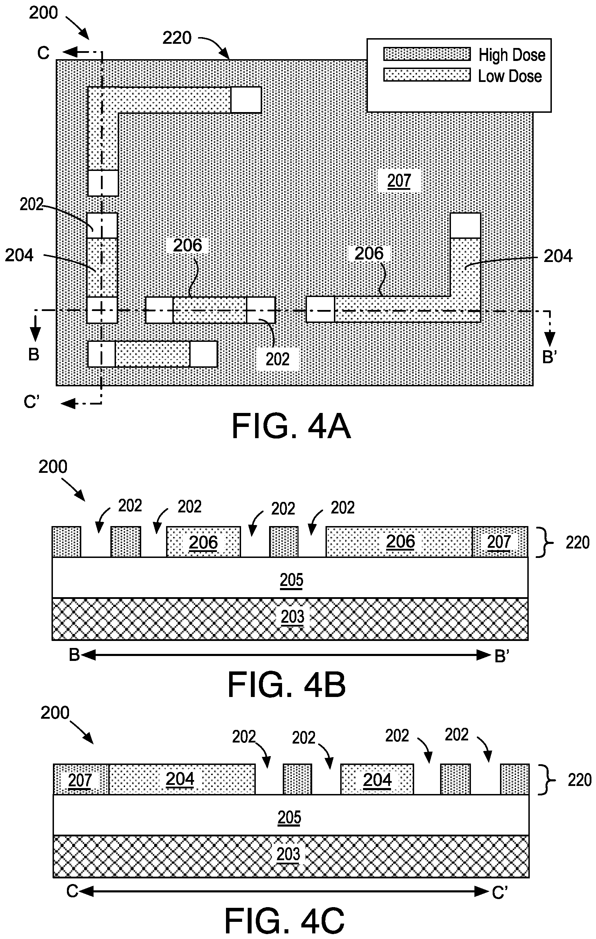

Returning to FIG. 2, methods 201 continue at block 240 where a first develop process removes the via region of the resist that received no exposure (a null dose) at block 230. In the example illustrated in FIG. 4A, resist via regions 202 have been developed to clear, exposing underlying thin film 205. Line regions 204, 206 that received a higher dose than via regions 202 remain undeveloped, as does field region 207. FIG. 4B and 4C further illustrate fully developed via regions 202, incompletely developed line regions 204, 206 and undeveloped field region 207.

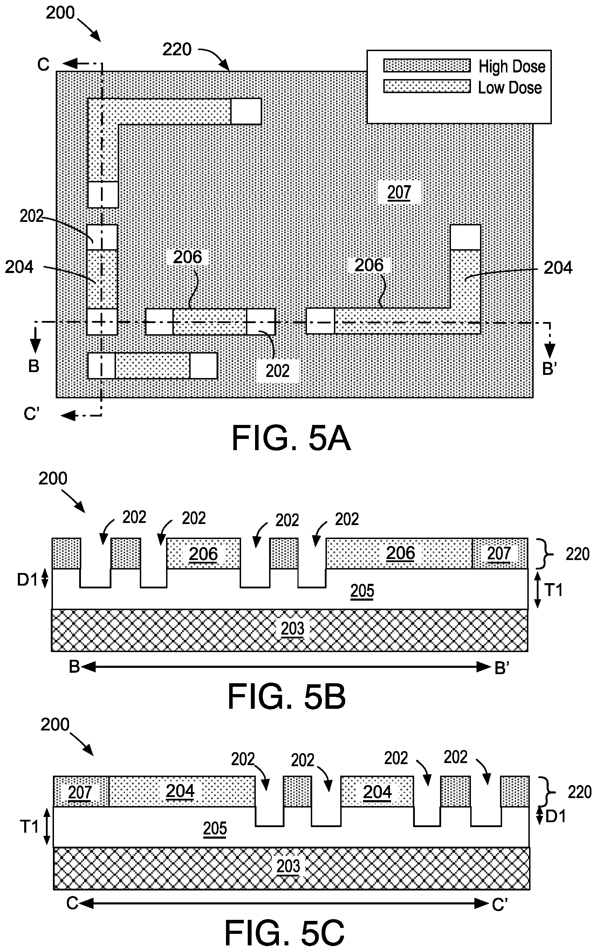

Returning to FIG. 2, methods 201 continue at block 250 where an etch process masked by the photoresist transfers the via region of the resist into a via region within the workpiece by removing at least a portion of thin film material underlying the photoresist. Any etch process suitable for the composition of the thin film material may be practiced at block 250 as embodiments herein are not limited in this respect. In the example illustrated in FIG. 5A, a partial thickness of underlying thin film 205 remains in via regions 202, for example following a fluorocarbon-based plasma etch process suitable for a silicon-based dielectric material. As further illustrated in FIG. 5B and 5C, via regions 202 extend into thin film 205 by a thickness or depth D1. In exemplary embodiments, depth D1 is less than the full thickness T1 of thin film 205. Incompletely developed line regions 204, 206 and undeveloped field region 207 are sufficiently resilient to survive the via etch process. While it is advantageous to limit the via etch depth D1, for example to limit consumption of undeveloped resist regions, via etch depth D1 may also be increased to be equal to thickness T1.

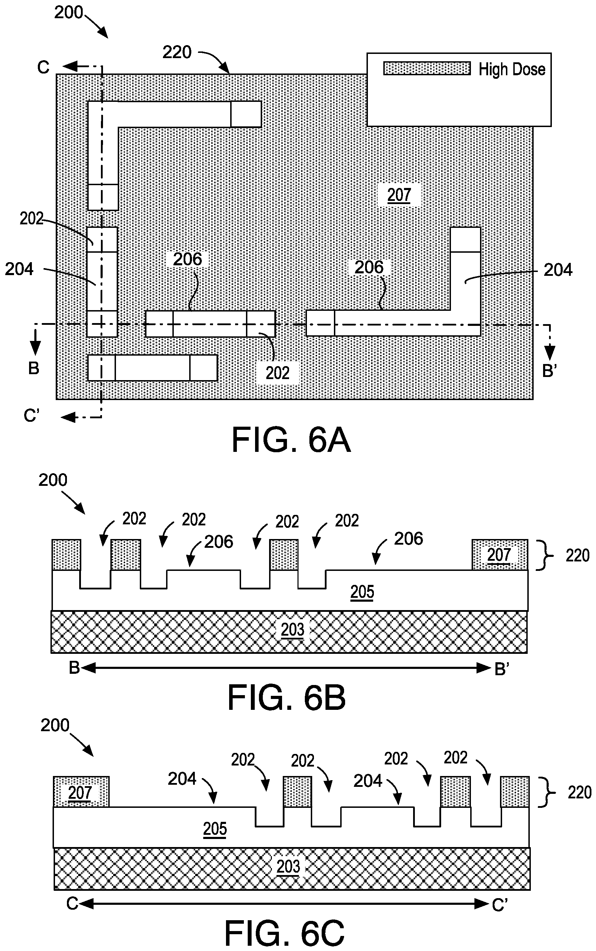

Returning to Fig. 2, methods 201 continue at block 260 where a second develop process removes the line region of the resist that received a greater exposure (lose dose) at block 230. In some embodiments, the second develop process is different than the first develop process. In other embodiments, the second develop process is the same as the first develop process and a cumulative effect of the additional develop time clears regions that received a higher dose than the via regions which developed in a first pass. In the example illustrated in FIG. 6A, resist line regions 204, 206 have been developed to clear, exposing underlying thin film 205. Field region 207, having received a higher dose than line regions 204, 206 remains undeveloped. FIG. 6B and 6C further illustrate fully developed line regions 204, 206 and the surrounding undeveloped field region 207.

Returning to FIG. 2, methods 201 continue at continue at block 270 where an etch process masked by the photoresist transfers the resist line opening into a line feature within the workpiece by removing at least a portion of thin film material underlying the photoresist. For embodiments where the via etch at block 250 etches only partially through the thin film material, the via etch may be continued at block 270 concurrently with the line etch. Any etch process suitable for the composition of the thin film material may be practiced at block 270 as embodiments herein are not limited in this respect. In some examples, substantially the same etch process practiced at block 250 is practiced at block 270. Methods 201 are completed at output 280 where any remaining mask material is stripped and the line and via regions are metallized, for example with any suitable dual damascene metallization process. IC fabrication may then be continued, for example to form additional levels of interconnect metallization.

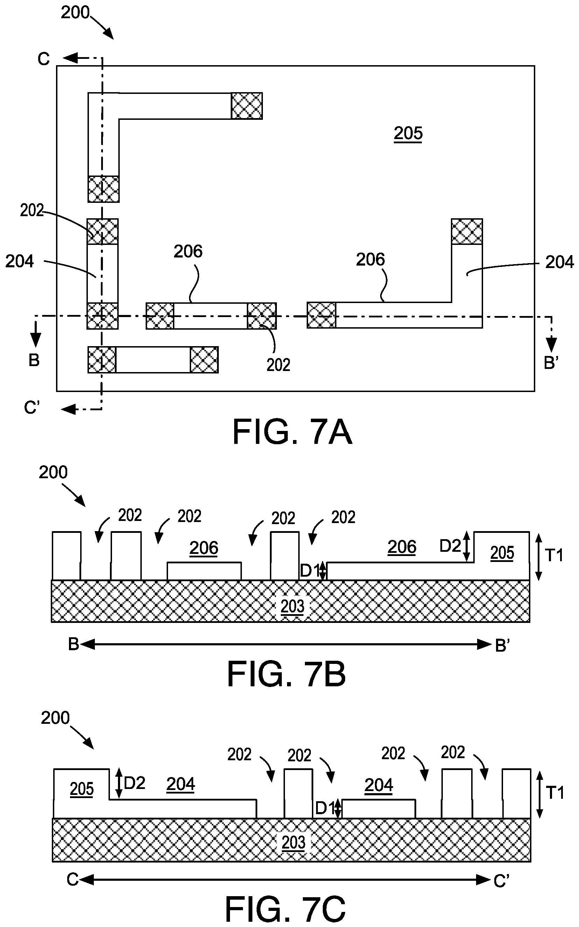

In the example illustrated in FIG. 7A, a partial thickness of underlying thin film 205 remains in line regions 204 and 206, for example following a fluorocarbon-based plasma etch process suitable for a silicon-based dielectric material. As further illustrated in FIG. 7B and 7C, line regions 204, 206 extend into thin film 205 by a thickness or depth D2 while via regions 202 extend into thin film 205 by the additional depth D1. In exemplary embodiments, depth D2 is less than film thickness T1 of thin film 205 while the summation of depths D1 and D2 is equal to film thickness T1 so that substrate 203 is exposed within via regions 202. Field region 207 retains thin film thickness T1.

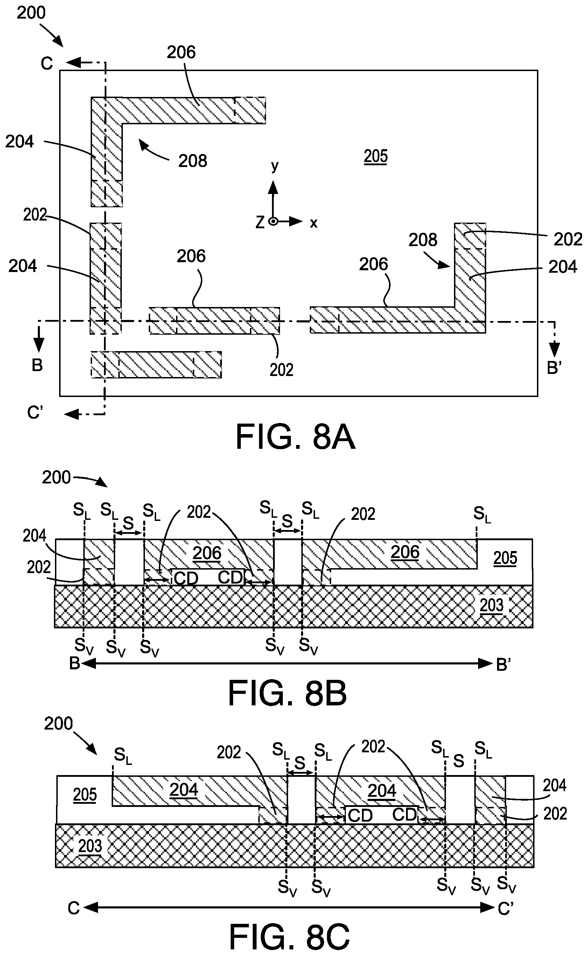

FIG. 8A-8C further illustrate workpiece 200 following metallization of the via and line regions patterned into thin film material 205. In exemplary embodiments, the metallization comprises predominantly copper. Other conductive materials are also possible. Although not illustrated, interconnect metallization may comprise any of an adhesion layer, a barrier layer, and a fill material. As shown, via regions 202 have no misalignment both with first line regions 204 extending in a first dimension (e.g., y-dimension) and second line regions 206 extending in a second dimension (e.g., x-dimension). As used herein, "no misalignment" means that sidewalls of a via region of the interconnect metallization are continuous with sidewalls of a line region of the interconnect metallization and there is no lateral offset, shift, or other discontinuity between sidewalls of the via region and the line region. Notably, and in accordance with embodiments herein, there is no (zero) misalignment within the x-y plane of the workpiece such that via sidewalls are precisely in alignment with line sidewalls within both the x-dimension (as illustrated in FIG. 8B) and the y-dimension (as illustrated in FIG. 8C).

In FIG. 8B, a via region 202 in direct contact with a line region 204 has a pair of opposite via sidewalls Sv that have no misalignment or lateral shift in the x-dimension from the pair of opposite line sidewalls S_{L} defining the transverse line width. Hence, for line region 204 there is no discontinuity between via sidewalls Sv and line sidewalls S_{L} within the x-dimension. A width of via region 202 is therefore essentially the same as the transverse width of line region 204. As further illustrated in FIG. 8B, another via region 202 in contact with orthogonal line region 206 also has a via sidewall Sv with no misalignment or lateral shift within the x-dimension from a line sidewall S_{L} defining one longitudinal end of line region 204. Accordingly, a space S between adjacent line regions can be minimized for greater line density as line regions 204, 206 do not require a non-zero overlap of via regions 202. Two adjacent via regions 202 are similarly separated by space S because via regions 202 are in exact alignment with the line end and width sidewall, Notably, each of line sidewall S_{L} and via sidewall Sv may be tapered or sloped so that space S may vary with sidewall depth, but continuity between line sidewall S_{L} and via sidewall Sv is nevertheless maintained. Exact alignment of via regions 202 and line regions 204, 206 therefore remains evident regardless of sidewall verticality.

Since a line region 206 has a longitudinal length between two opposite line ends that is significantly longer (e.g., at least two times longer) than an x-dimensional width of via region 202, only one via sidewall Sv is in perfect alignment with line sidewall S_{L} within the x-dimension. However, as further shown in FIG. 8B, two via regions 202 in contact with opposite ends of line region 206 together have a pair of outer sidewalls Sv that have no misalignment with corresponding line sidewalls S_{L}. Although via dimensions may vary across via regions 202, in some exemplary embodiments via regions 202 in contact with opposite ends of line region 206 have the same width or critical dimension (CD).

As further shown in FIG. 8C, all line sidewalls S_{L} similarly have no misalignment with via sidewalls Sv within the orthogonal y-dimension. Hence, the line region 204 which has a pair of line sidewalls S_{L} with no misalignment with a first pair of via sidewalls Sv within the x-dimension also has another pair of sidewalls S_{L}, one of which has no misalignment with one of another pair of via sidewalls Sv in the y-dimension. Likewise, the line region 206 which has a pair of line sidewalls S_{L} with no misalignment with a first pair of via sidewalls Sv within the y-dimension also has another pair of sidewalls S_{L}, one of which has no misalignment with one of another pair of via sidewalls Sv in the x-dimension. The perfect alignment between via regions 202 and line regions 204, 206 may therefore be considered a two-dimensional (2D) self-alignment of a first level of interconnect features (e.g., lines or vias) with a second level of interconnect features (e.g., vias or lines). For two line structures 208 illustrated FIG. 8A-8C that have both a first segment with a longitudinal length in the x-dimension and a second segment with a longitudinal length in the y-dimension, a first via region in contact with the first segment has a pair of opposite via sidewalls Sv in perfect alignment with a pair of opposite line sidewalls S_{L} while a second via region in contact with the second segment has another pair of opposite via sidewalls Sv in perfect alignment with another pair of opposite line sidewalls S_{L}.

Although FIG. 8A-8C illustrate feature sidewall alignment within two orthogonal dimensions, the exact alignment illustrated is possible for any/all orientations within the x-y plane because the lack of any misalignment is a direct result of the concurrent imaging of line regions 204, 206 with via regions 202 rather than a result of some complex multi-patterning scheme capable of optimizing alignment only within one dimension.

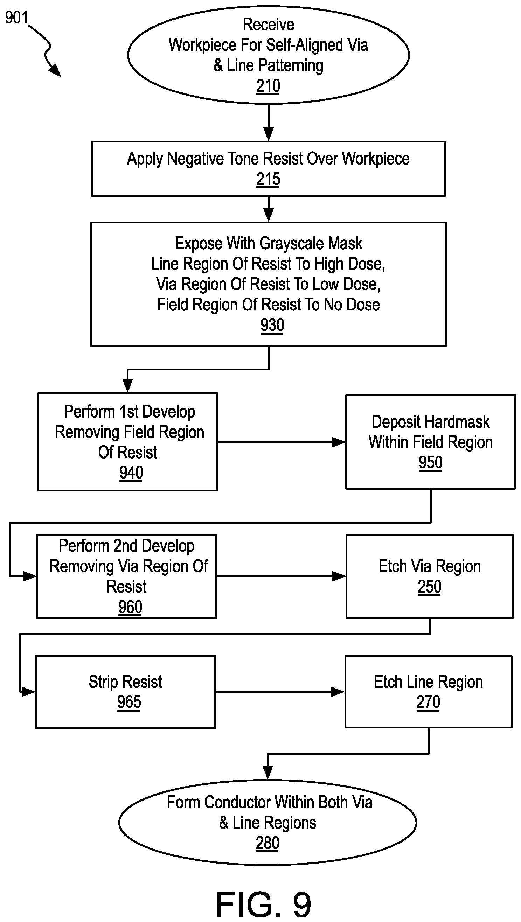

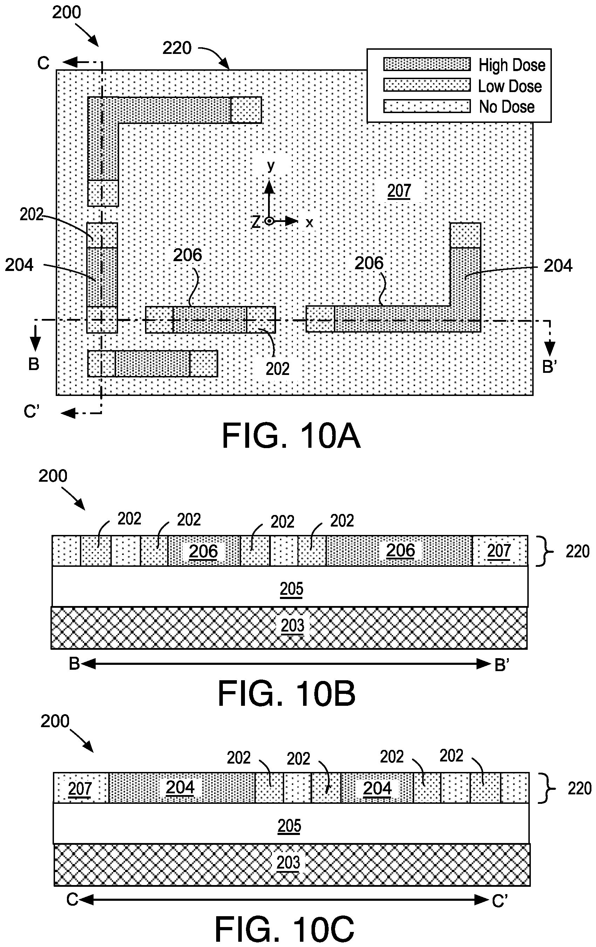

As noted above for methods 101, heterogeneous features defined with grayscale lithography may be transferred into a workpiece with an intervening thin film etch or thin film deposition. FIG. 9 illustrates a flow diagram of methods 901 further illustrating fabrication of an IC interconnect structure having no misalignment between vias and lines, in accordance with some alternative embodiments where a selective film deposition is performed between successive resist develop iterations. Relative to methods 201, a selective deposition of hardmask material in methods 901 may reduce the etch resistance required of a grayscale photoresist composition. FIG. 10A-10C, 11A-11C, 12A-12C, 13A-13C, 14A-14C and 15A-15C illustrate plan and orthogonal cross-sectional views of an IC workpiece 200 evolving as methods 901 are practiced in accordance with some illustrative embodiments.

Referring first to FIG. 9, methods 901 again begin at input 210 with receipt of a workpiece having a dielectric thin film over a working surface. Interconnect structures comprising a level of vias below a level of lines are to be fabricated into the dielectric thin film. At block 215, a negative tone resist is applied over the workpiece. The resist applied at block 215 may have any of the attributes described above including a sufficiently dose-dependent develop response to define three exposure/develop levels. At block 930, the photoresist is exposed with a grayscale mask, such as any of those described above in the context of methods 101. At block 930, a line region of the resist is exposed to a first (high) dose, a via region of the resist is exposed to a second (low) dose, and a field region of the resist is exposed to a third (null) dose. Any suitable post-exposure bake may be practiced at block 930 as embodiments herein are not limited in this respect.

In the example illustrated in FIG. 10A, resist 220 is over an area of a workpiece 200. Resist 220 has been exposed with a single imaging process according to a grayscale mask. Resist field regions 207 have received a null dose. Resist via regions 202 have received a low, but non-zero, dose. Resist 220 further comprises first line regions 204 and second line regions 206, which have both received a high dose.

FIG. 10B illustrates a cross-sectional view of workpiece 200 along the B-B' line illustrated in FIG. 10A. FIG. 10C illustrates a cross-sectional view of workpiece 200 along the C-C' line illustrated in FIG. 10A. As shown, resist 220 is over a workpiece thin film 205, which in exemplary embodiments comprises a dielectric material. The dielectric material may be any of those described above, for example comprising silicon and oxygen. Thin film 205 may also comprise multiple layers, for example including a few nanometers thin layer of metallization on the working surface. Workpiece 200 further comprises a substrate 203, which may further comprise any number of thin film layers and crystalline semiconductor device layers over a handling/support material (e.g., monocrystalline silicon, etc.).

Returning to FIG. 9, methods 901 continue at block 940 where a first develop process removes the field region of the resist that received no exposure (a null dose) at block 930. Methods 901 continue at block 950 where a hardmask material is selectively deposited upon the workpiece film exposed by the first develop. Surrounding regions of resist retard deposition of the hardmask material. Although the hardmask materials and deposition processes practiced at block 950 may vary with implementation, in some examples block 950 entails a surface selective autocatalytic vapor deposition process or the formation of a self-assembled monolayer (SAM) material, which may also be introduced in the vapor phase and "self-assembled" by forming a highly selective bond to a surface of the workpiece thin film relative to surrounding resist regions where bond energy is less favorable. Selective deposition may be facilitated in some embodiments where workpiece thin film 205 comprises a surface layer of one or more metals that promote material deposition.

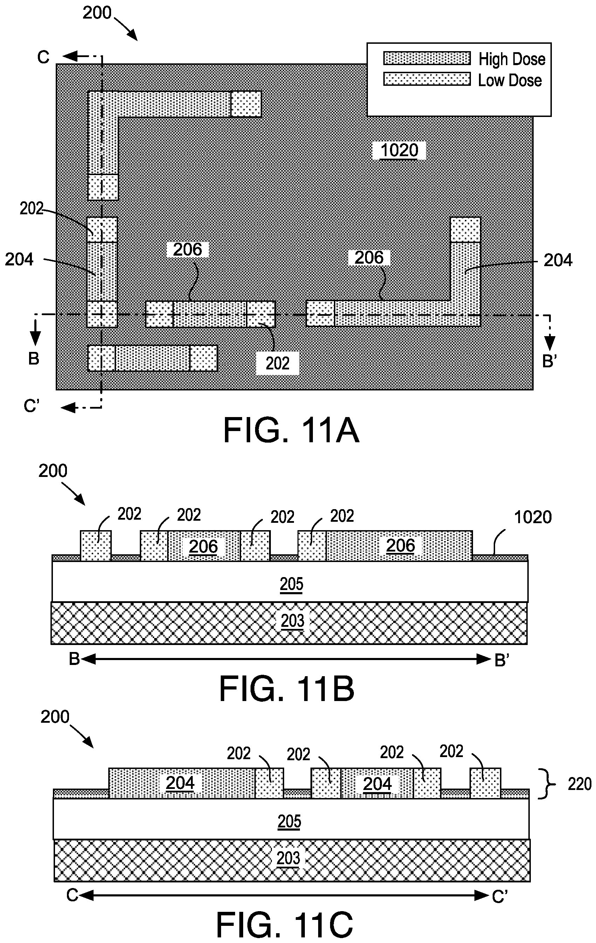

In the example illustrated in FIG. 11A, via regions 202 remain undeveloped, as do line regions 204, 206. Within field regions, a hardmask material 1020 has been selectively deposited upon a surface of thin film 205. FIG. 11B and 11C further illustrate hardmask material 1020 within field regions adjacent to undeveloped via regions 202 and line regions 204, 206. Hardmask material 1020 may have any as-deposited thickness sufficient to function as a mask during subsequent etching of thin film 205.

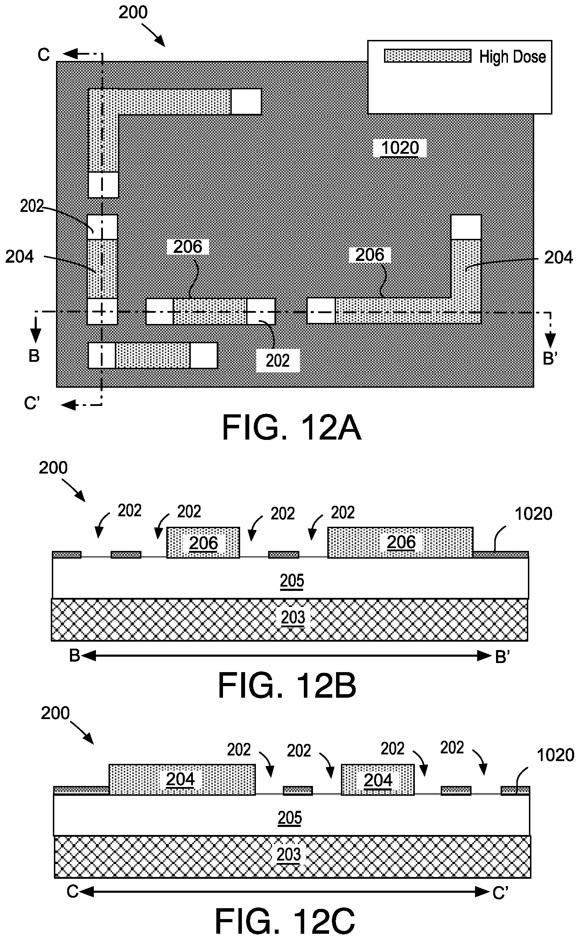

Returning to FIG. 9, methods 901 continue at block 960 where a second develop process removes the via region of the resist that received a non-zero exposure (low dose) at block 930. In some embodiments, the second develop process is different than the first develop process performed at block 940. In other embodiments, the second develop process is the same as the first develop process and the cumulative effect of the additional develop time clears regions that received a greater dose than the field region, which developed in a first pass. FIG. 12A-12C further illustrate the exemplary workpiece 200 following a second development of the photoresist, which removes via regions 202 while retaining line regions 204, 206 that received a higher exposure dose.

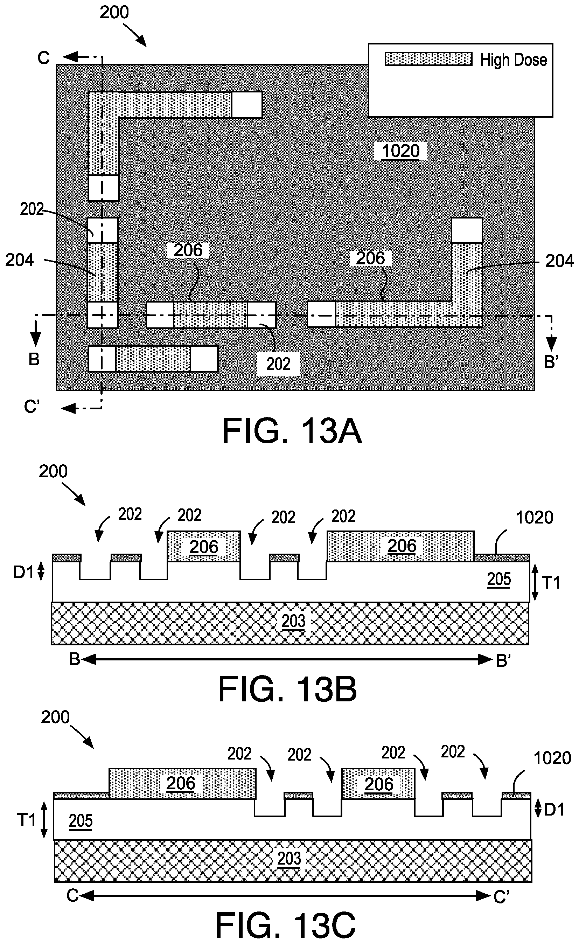

Returning to FIG. 9, methods 901 continue at block 250 where an etch process masked by a summation of the hardmask deposited at block 950 and remaining photoresist. The etch process transfers the via opening into a via feature within the workpiece by removing at least a portion of thin film material underlying the photoresist. Any etch process suitable for the composition of the thin film material may be practiced at block 250 as embodiments herein are not limited in this respect. In the example illustrated in FIG. 13A, a partial thickness of underlying thin film 205 remains in via region 202, for example following a fluorocarbon-based plasma etch process suitable for a silicon-based dielectric material. As further illustrated in FIG. 13B and 13C, via region 202 extend into thin film 205 by a thickness or depth D1. In exemplary embodiments, depth D1 is less than the full thickness T1 of thin film 205. Undeveloped line regions 204, 206 and the field region protected by hardmask 1020 are unetched by the via etch process. While it is advantageous to limit the via etch depth D 1, for example to limit consumption of undeveloped resist regions, and/or hardmask 1020, via etch depth D1 may instead be equal to thickness T1.

Returning to Fig. 9, methods 901 continue at block 965 where remaining photoresist is stripped. Methods 901 then continue at block 270 where an etch process masked only by the hardmask transfers a line opening into a line feature within the workpiece by removing at least a portion of thin film material underlying the photoresist. For embodiments where the process performed at block 250 etches only partially through the thin film material, the via etch may continue at block 270 concurrently with the line etch. Any etch process suitable for the composition of the thin film material may be practiced at block 270 as embodiments herein are not limited in this respect. In some examples, substantially the same etch process practiced at block 250 is practiced at block 270.

Methods 901 are completed at output 280 where and line and via regions are metallized, for example with any suitable dual damascene metallization process. Hardmask material within the field region may be removed at this time (e.g., with a metallization planarization process). For embodiments where workpiece thin film 205 comprises a surface layer of one or more metals utilized in selective hardmask material deposition, that surface layer is advantageously also removed from the field regions (e.g., with the metallization planarization process). Alternatively, in embodiments where there are only electrical insulators within the field region, hardmask material may be retained as a permanent feature of an interconnect structure. IC fabrication may then be continued, for example to form additional levels of interconnect metallization, each of which may further include another iteration of methods 901.

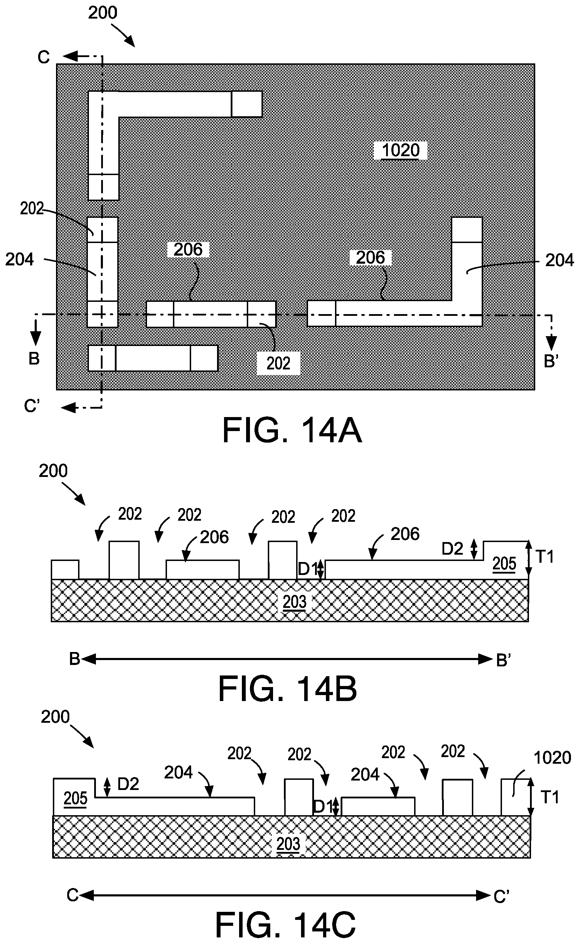

In the example illustrated in FIG. 14A, a partial thickness of underlying thin film 205 remains in line regions 204 and 206, for example following a fluorocarbon-based plasma etch process suitable for a silicon-based dielectric material. As further illustrated in FIG. 14B and 14C, line regions 204, 206 extend into thin film 205 by a thickness or depth D2 while via regions 202 extend into thin film 205 by the additional depth D1. In exemplary embodiments, depth D2 is less than film thickness T1 of thin film 205 while the summation of depths D1 and D2 is equal to film thickness T1 so that substrate 203 is exposed within via regions 202. Field region 207 retains thin film thickness T1.

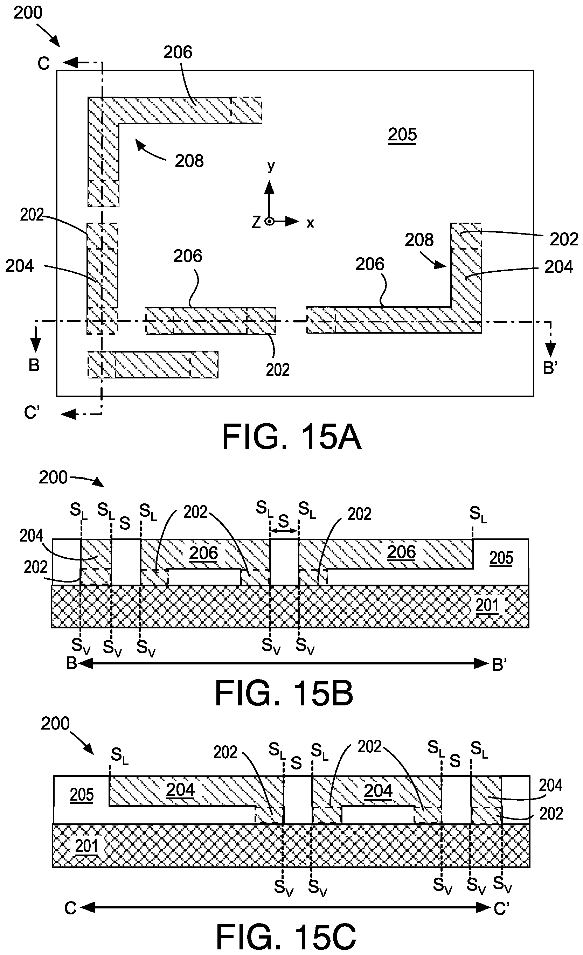

FIG. 15A-15C further illustrate workpiece 200 following metallization of the via and line regions patterned into thin film material 205. In exemplary embodiments, the metallization comprises predominantly copper. Other conductive materials are also possible. Although not illustrated, interconnect metallization may comprise any of an adhesion layer, a barrier layer, and a fill material. As shown, via regions 202 have no misalignment both with first line regions 204 extending in a first dimension (e.g., y-dimension) and second line regions 206 extending in a second dimension (e.g., x-dimension). As described above, "no misalignment" means that sidewalls of a via region of the interconnect metallization are continuous with sidewalls of a line region of the interconnect metallization and there is no lateral offset, shift or other discontinuity between sidewalls of the via and line regions. Notably, and in accordance with embodiments herein, there is no misalignment within the x-y plane of the workpiece such that via sidewalls are precisely in alignment with line sidewalls within both the x-dimension (as illustrated in FIG. 14B) and the y-dimension (as illustrated in FIG. 14C).

In FIG. 15B, a via region 202 in direct contact with a line region 204 has a pair of opposite via sidewalls Sv that have no misalignment or lateral shift in the x-dimension from the pair of opposite line sidewalls S_{L} defining the transverse line width. Hence, for line region 204 there is no discontinuity between via sidewalls Sv and line sidewalls S_{L} within the x-dimension. A width of via region 202 is therefore essentially the same as the transverse width of line region 204. As further illustrated in FIG. 15B, another via region 202 in contact with orthogonal line region 206 also has a via sidewall Sv with no misalignment or lateral shift within the x-dimension from a line sidewall S_{L} defining one longitudinal end of line region 204. Accordingly, a space S between adjacent line regions can be minimized for greater line density as line regions 204, 206 do not require a non-zero overlap of via regions 202. Two adjacent via regions 202 are similarly separated by space S because via regions 202 are in exact alignment with the line end and width sidewall. Notably, each of line sidewall S_{L} and via sidewall Sv may be tapered or sloped so that space S may vary with sidewall depth, but continuity between line sidewall S_{L} and via sidewall Sv is nevertheless maintained. Exact alignment of via regions 202 and line regions 204, 206 therefore remains evident regardless of sidewall verticality.

Considering a line region 206 has a longitudinal length between two opposite line ends that is significantly longer (e.g., at least two times longer) than an x-dimensional width of via region 202, only one via sidewall Sv is in perfect alignment with line sidewall S_{L} within the x-dimension. However, as further shown in FIG. 15B, two via regions 202 in contact with opposite ends of line region 206 together have a pair of outer sidewalls Sv that have no misalignment with corresponding line sidewalls S_{L}. Although via dimensions may vary across via regions 202, in some exemplary embodiments via regions 202 in contact with opposite ends of line region 206 have the same width or CD.

As further shown in FIG. 15C, all line sidewalls S_{L} similarly have no misalignment with via sidewalls Sv within the orthogonal y-dimension. Hence, the line region 204 which has a pair of line sidewalls S_{L} with no misalignment with a first pair of via sidewalls Sv within the x-dimension also has another pair of sidewalls S_{L}, one of which has no misalignment with one of another pair of via sidewalls Sv in the y-dimension. Likewise, the line region 206 which has a pair of line sidewalls S_{L} with no misalignment with a first pair of via sidewalls Sv within the y-dimension also has another pair of sidewalls S_{L}, one of which has no misalignment with one of another pair of via sidewalls Sv in the x-dimension. The perfect alignment between via regions 202 and line regions 204, 206 may therefore be considered a two-dimensional (2D) self-alignment of a first level of interconnect features (e.g., lines or vias) with a second level of interconnect features (e.g., vias or lines).

For two line structures 208 illustrated FIG. 15A-15C that have both a first segment with a longitudinal length in the x-dimension and a second segment with a longitudinal length in the y-dimension, a first via region in contact with the first segment has a pair of opposite via sidewalls Sv in perfect alignment with a pair of opposite line sidewalls S_{L} while a second via region in contact with the second segment has another pair of opposite via sidewalls Sv in perfect alignment with another pair of opposite line sidewalls S_{L}.

Although FIG. 15A-15C illustrate feature sidewall alignment within two orthogonal dimensions, the exact alignment illustrated is possible for any/all orientations within the x-y plane because the lack of any misalignment is a direct result of the concurrent imaging of line regions 204, 206 with via regions 202 rather than a result of a complex multi-patterning scheme capable of optimizing alignment only within one dimension.

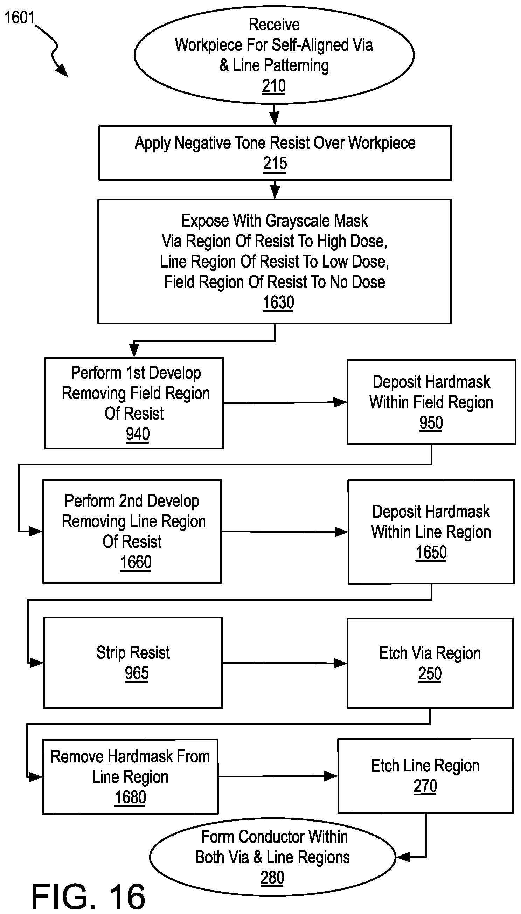

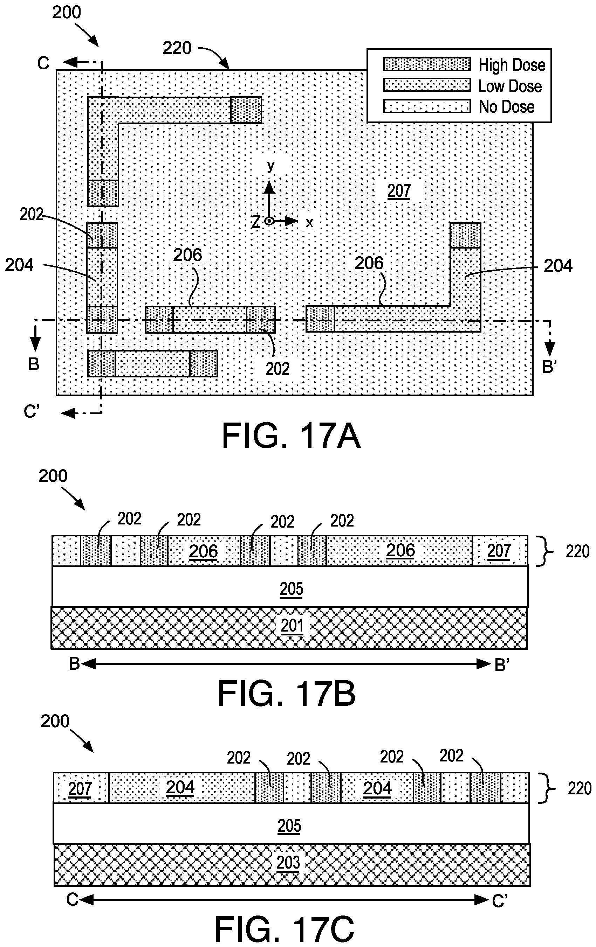

FIG. 16 illustrates a flow diagram of methods 1601 further illustrating fabrication of an IC interconnect structure having no misalignment between vias and lines, in accordance with some alternative embodiments with multiple selective film depositions and etches between successive resist develop iterations. Relative to methods 901, multiple selective depositions of hardmask material in methods 1601 may eliminate any etch resistance requirement from a grayscale photoresist composition. FIG. 17A-17C, 18A-18C, 19A-19C, 20A-20C, and 21A-21C illustrate plan and orthogonal cross-sectional views of an IC structure evolving as the methods 1601 are practiced in accordance with some embodiments.

Referring first to FIG. 16, methods 1601 begin at input 210 with receipt of a workpiece having a dielectric thin film over a working surface. Interconnect structures comprising a level of vias below a level of lines are to be fabricated into the dielectric thin film. At block 215, a negative tone resist is applied over the workpiece. The resist applied may have any of the attributes described above in the context of methods 101 (FIG. 1A) including a sufficiently dose-dependent develop response to define three exposure/develop levels. At block 1630 (FIG. 16), the photoresist is exposed with a grayscale mask, such as any of those described above in the context of methods 101. At block 1630, a via region of the resist is exposed to a first (high) dose, a line region of the resist is exposed to a second (low) dose, and a field region of the resist is exposed to a third (null) dose. Any suitable post-exposure bake may be practiced at block 1630 as embodiments herein are not limited in this respect.

In the example illustrated in FIG. 17A, resist 220 is over an area of a workpiece 200. Resist 220 has been exposed with a single imaging process according to a grayscale mask. Resist field regions 207 have received a null dose. Resist line regions 204, 206 have received a low, but non-zero, dose. Resist 220 further comprises via regions 202, which have received a high dose.

FIG. 17B illustrates a cross-sectional view of workpiece 200 along the B-B' line illustrated in FIG. 17A. FIG. 17C illustrates a cross-sectional view of workpiece 200 along the C-C' line illustrated in FIG. 17A. As shown, resist 220 is over a workpiece thin film 205, which in exemplary embodiments comprises a dielectric material. The dielectric material may be any of those described above, for example comprising silicon and oxygen. Thin film 205 may also comprise multiple layers, for example including a few nanometers thin layer of metallization on the working surface. Workpiece 200 further comprises a substrate 203, which may further comprise any number of thin film layers and crystalline semiconductor device layers over a handling/support material (e.g., monocrystalline silicon, etc.).

Returning to FIG. 16, methods 1601 continue at block 940 where a first develop process removes the field region of the resist that received no exposure (a null dose) at block 1630. Methods 1601 continue at block 950 where a hardmask material is selectively deposited upon the workpiece film exposed by the first develop. Surrounding regions of resist retard deposition of the hardmask material. Although the hardmask materials and deposition processes practiced at block 950 may vary with implementation, in some examples block 950 entails a surface selective autocatalytic vapor deposition process or the formation of a self-assembled monolayer (SAM) material, which may also be introduced in the vapor phase and "self-assembled" by forming a highly selective bond to a surface of the workpiece thin film relative to surrounding resist regions where the bond energy is unfavorable. Selective deposition may be facilitated for some embodiments where thin film 205 comprises a surface layer of one or more metals that promote material deposition.

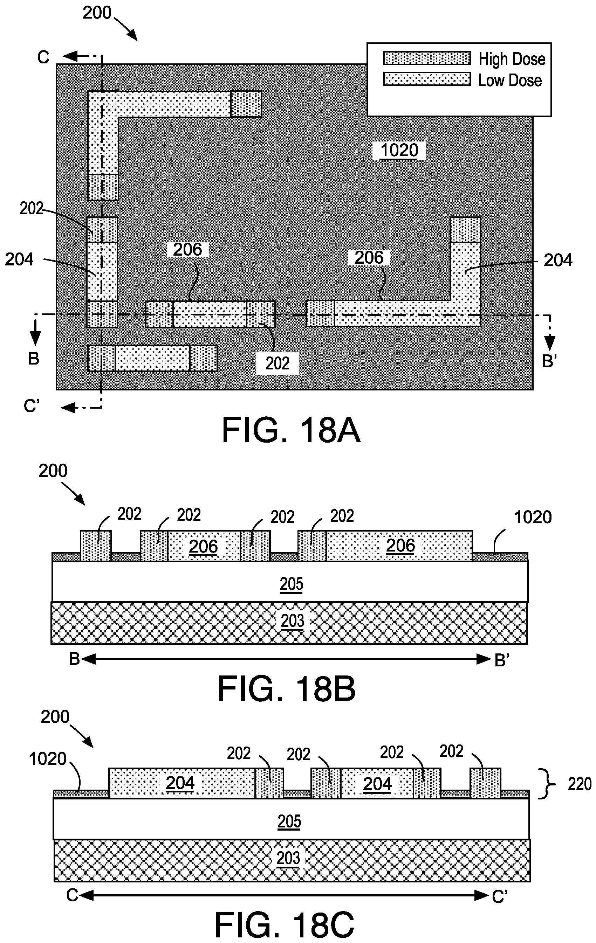

In the example illustrated in FIG. 18A via regions 202 remain undeveloped, as do line regions 204, 206. Within field regions, hardmask material 1020 has been selectively deposited upon a surface of thin film 205. FIG. 18B and 18C further illustrate hardmask material 1020 within field regions adjacent to undeveloped via regions 202 and line regions 204, 206. Hardmask material 1020 may have any as-deposited thickness sufficient to function as a mask during subsequent etching of thin film 205.

Returning to FIG. 16, methods 1601 continue at block 1660 where a second develop process removes the line region of the resist that received a non-zero exposure (low) dose at block 1630. In some embodiments, the second develop process is different than the first develop process performed at block 940. In other embodiments, the second develop process is the same as the first develop process and the cumulative effect of the additional develop time clears resist regions that received a greater dose than the field region, which developed in a first pass.

At block 1650 hardmask material is selectively deposited upon underlying thin film material within the line region exposed at block 1660. In some exemplary embodiments, the deposition process performed at block 1650 is the same as the deposition process performed at block 950. Accordingly, a thickness of hardmask material deposited at block 950 may be increased by the material deposited at block 1650. In embodiments, where the deposition process performed at block 1650 is different than the deposition process performed at block 950, a multi-layered hardmask stack may be formed within the field regions while a single layered hardmask stack is formed within the line regions.

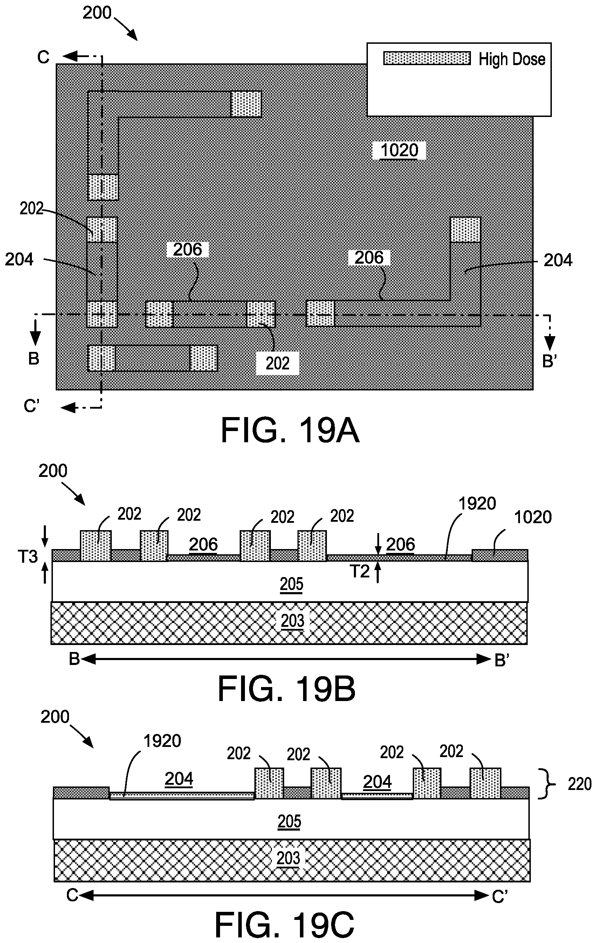

FIG. 19A-19C further illustrate workpiece 200 following a second development of the more exposed photoresist, and a second selective thin film material deposition. As shown, line regions have a hardmask material 1920 of a thickness T2, less than a thickness T3 of hardmask material 1020.

Returning to FIG. 16, methods 1601 continue at block 965 where remaining photoresist is stripped. An etch process at block 250, as masked by a summation of the two hardmask materials deposited at blocks 950 and 1650, defines via regions with the workpiece thin film. The etch process transfers the via regions into the workpiece by removing at least a portion of thin film material not protected by the hardmask materials. Any etch process suitable for the composition of the thin film material may be practiced at block 250 as embodiments herein are not limited in this respect. At block 1680, hardmask material deposited at block 1660 is then removed from line regions, for example with an etchback process, while at least a partial thickness of the hardmask material deposited at block 950 is retained.

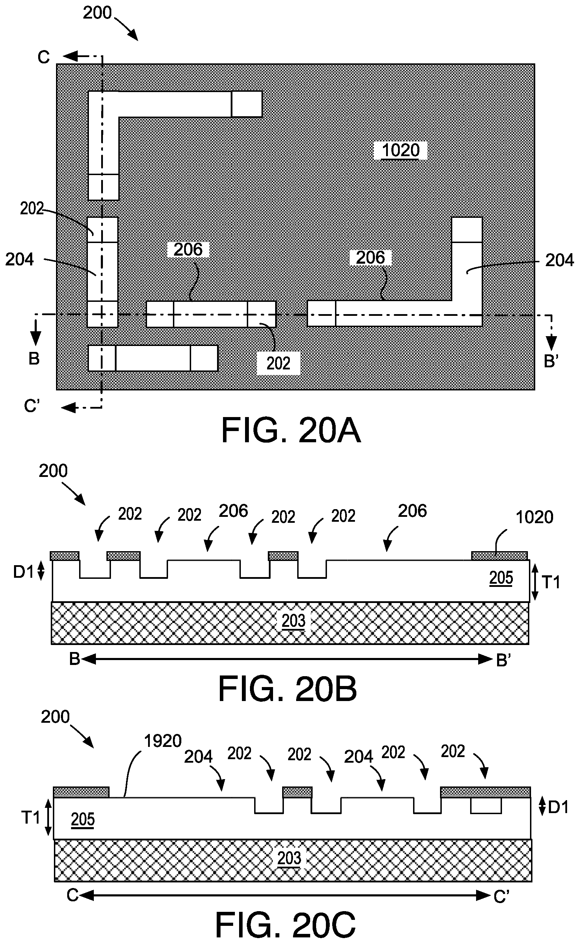

In the example illustrated in FIG. 20A, a partial thickness of thin film 205 remains in via regions 202, for example following a fluorocarbon-based plasma etch process suitable for a silicon-based dielectric material. As further illustrated in FIG. 20B and 20C, via regions 202 extend into thin film 205 by a thickness or depth D1. In exemplary embodiments, depth D1 is less than the full thickness T1 of thin film 205. Undeveloped line regions 204, 206 are unetched by the via etch process. While it is advantageous to limit the via etch depth D 1, for example to limit consumption of undeveloped resist regions, and/or hardmask 1020, via etch depth D1 may also be equal to thickness T1. Following the via etch process, or another anisotropic etch process specific to hardmask material, a full thickness of underlying thin film 205 is exposed within line regions 204, 206.

Methods 1601 (FIG. 16) continue at block 270 where an etch process masked only by the remaining hardmask transfers line regions into workpiece by removing at least a portion of thin film material underlying the photoresist. For embodiments where the process performed at block 250 etches only partially through the thin film material, the via etch may continue at block 270 concurrently with the line etch. Any etch process suitable for the composition of the thin film material may be practiced at block 270 as embodiments herein are not limited in this respect. In some examples, substantially the same etch process practiced at block 250 is practiced at block 270.

Methods 1601 are completed at output 280 where remaining mask material is stripped and line and via regions are metallized, for example with any suitable dual damascene metallization process. Hardmask material within the field region may be removed at this time (e.g., with a metallization planarization process). For embodiments where workpiece thin film 205 comprises a surface layer of one or more metals utilized in selective hardmask material deposition, that surface layer is advantageously also removed from the field regions (e.g., with the metallization planarization process). Alternatively, in embodiments where there are only electrical insulators within the field region, hardmask material may be retained as a permanent feature of an interconnect structure. IC fabrication may then be continued, for example to form additional levels of interconnect metallization, each of which may further include another iteration of methods 1601.

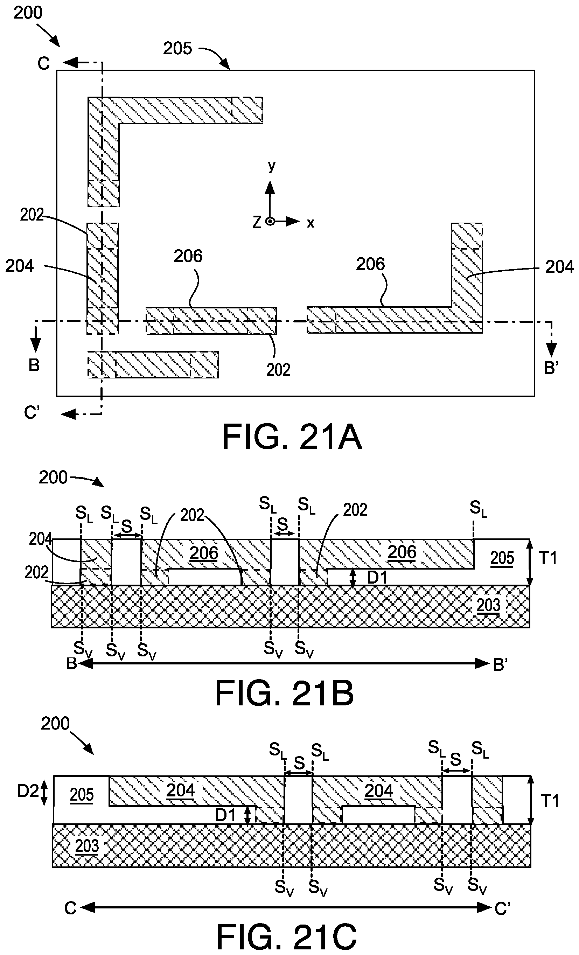

In the example illustrated in FIG. 21A, a partial thickness of underlying thin film 205 remains in line regions 204 and 206, for example following a fluorocarbon-based plasma etch process suitable for a silicon-based dielectric material. As further illustrated in FIG. 21B and 21C, line regions 204, 206 extend into thin film 205 by a thickness or depth D2 while via regions 202 extend into thin film 205 by the additional depth D1. In exemplary embodiments, depth D2 is less than film thickness T1 of thin film 205 while the summation of depths D1 and D2 is equal to film thickness T1 so that substrate 203 is exposed within via regions 202. Field region 207 retains thin film thickness T1.

FIG. 21A-21C further illustrate workpiece 200 following metallization of the via and line regions patterned into thin film material 205. In exemplary embodiments, the metallization comprises predominantly copper. Other conductive materials are also possible. Although not illustrated, interconnect metallization may comprise any of an adhesion layer, a barrier layer, and a fill material. As shown, via regions 202 have no misalignment both with first line regions 204 extending in a first dimension (e.g., y-dimension) and second line regions 206 extending in a second dimension (e.g., x-dimension). As described above, "no misalignment" means that sidewalls of a via region of the interconnect metallization are continuous with sidewalls of a line region of the interconnect metallization and there is no lateral offset, shift, or other discontinuity between sidewalls of the via and line regions. Notably, and in accordance with embodiments herein, there is no misalignment within the x-y plane of the workpiece such that via sidewalls are precisely in alignment with line sidewalls within both the x-dimension (as illustrated in FIG. 21B) and the y-dimension (as illustrated in FIG. 21C).

In FIG. 21B, a via region 202 in direct contact with a line region 204 has a pair of opposite via sidewalls Sv that have no misalignment or lateral shift in the x-dimension from the pair of opposite line sidewalls S_{L} defining the transverse line width. Hence, for line region 204 there is no discontinuity between via sidewalls Sv and line sidewalls S_{L} within the x-dimension. A width of via region 202 is therefore essentially the same as the transverse width of line region 204. As further illustrated in FIG. 21B, another via region 202 in contact with orthogonal line region 206 also has a via sidewall Sv with no misalignment or lateral shift within the x-dimension from a line sidewall S_{L} defining one longitudinal end of line region 204. Accordingly, a space S between adjacent line regions can be minimized for greater line density as line regions 204, 206 do not require a non-zero overlap of via regions 202. Two adjacent via regions 202 are similarly separated by space S because via regions 202 are in exact alignment with the line end and width sidewall. Notably, each of line sidewall S_{L} and via sidewall Sv may be tapered or sloped so that space S may vary with sidewall depth, but continuity between line sidewall S_{L} and via sidewall Sv is nevertheless maintained. The exact alignment of via regions 202 and line regions 204, 206 therefore remains evident regardless of sidewall verticality.

Considering a line region 206 has a longitudinal length between two opposite line ends that is significantly longer (e.g., at least two times longer) than an x-dimensional width of via region 202, only one via sidewall Sv is in perfect alignment with line sidewall S_{L} within the x-dimension. However, as further shown in FIG. 21B, two via regions 202 in contact with opposite ends of line region 206 together have a pair of outer sidewalls Sv that have no misalignment with corresponding line sidewalls S_{L}. Although via dimensions may vary across via regions 202, in some exemplary embodiments via regions 202 in contact with opposite ends of line region 206 have the same width or critical dimension (CD).

As further shown in FIG. 21C, all line sidewalls S_{L} similarly have no misalignment with via sidewalls Sv within the orthogonal y-dimension. Hence, the line region 204 which has a pair of line sidewalls S_{L} with no misalignment to a first pair of via sidewalls Sv within the x-dimension also has another pair of sidewalls S_{L}, one of which has no misalignment to one of another pair of via sidewalls Sv in the y-dimension. Likewise, the line region 206 which has a pair of line sidewalls S_{L} with no misalignment to a first pair of via sidewalls Sv within the y-dimension also has another pair of sidewalls S_{L}, one of which has no misalignment to one of another pair of via sidewalls Sv in the x-dimension. The perfect alignment between via regions 202 and line regions 204, 206 may therefore be considered a two-dimensional (2D) self-alignment of a first level of interconnect features (e.g., lines or vias) with a second level of interconnect features (e.g., vias or lines).

For two of the line structures illustrated FIG. 21A-21C that have both a first segment with a longitudinal length in the x-dimension and a second segment with a longitudinal length in the y-dimension, a first via region in contact with the first segment has a pair of opposite via sidewalls Sv in perfect alignment with a pair of opposite line sidewalls S_{L} while a second via region in contact with the second segment has another pair of opposite via sidewalls Sv in perfect alignment with another pair of opposite line sidewalls S_{L}.

Although FIG. 21A-21C illustrate feature sidewall alignment within two orthogonal dimensions, the exact alignment illustrated is possible for any/all orientations within the x-y plane because exact alignment is a direct result of the concurrent imaging of line regions 204, 206 with via regions 202 rather than a result of some complex multi-patterning scheme capable of optimizing alignment only within one dimension.

The above examples illustrate how self-aligned interconnect lines and vias may be fabricated according to three levels of grayscale lithography. Three, or more, resist development levels may also be utilized to fabricate heterogenous via regions having more than one depth or height. Via regions of different heights would be similarly self-aligned to each other in contrast to multi-patterning techniques which necessarily incur alignment error. Three, or more, resist development levels may also be utilized to fabricate heterogenous line regions having more than one depth or height. Line regions of different heights would again be aligned to each other with no error. If more than three resist development levels are available (i.e., four levels), heterogenous via or line regions of more than two different heights can be fabricated. Alternatively, via (or line) regions of two different heights can be further self-aligned to corresponding line (or via) regions substantially as described above.

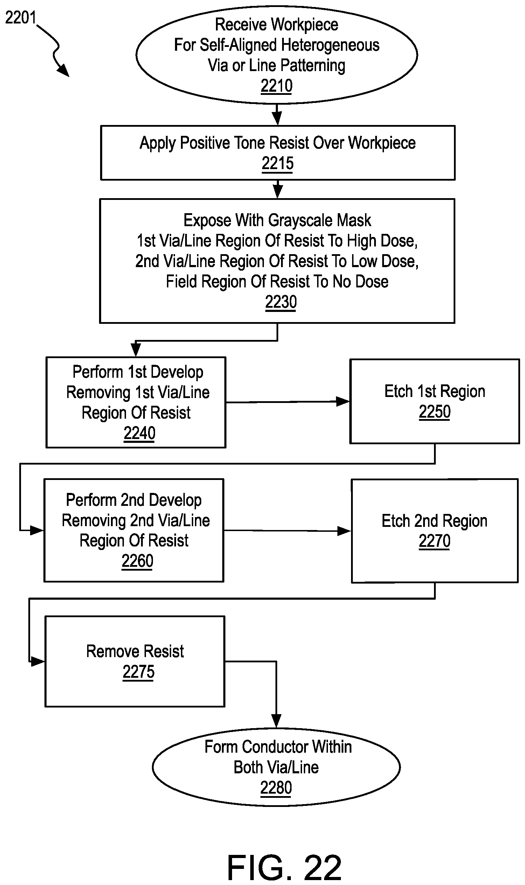

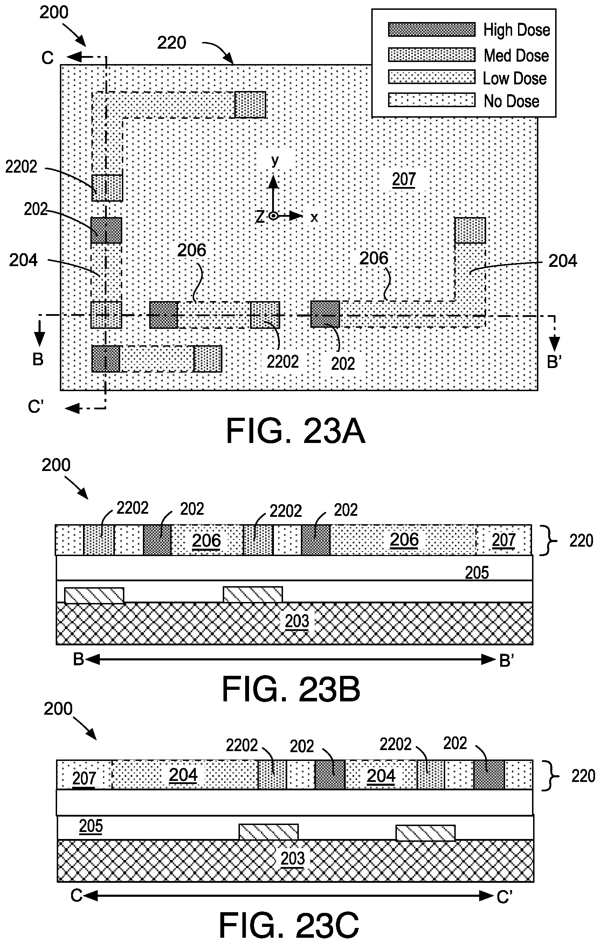

FIG. 22 illustrates a flow diagram of methods 2201 for forming an IC with no misalignment between vias of two different levels or heights, in accordance with some alternative IC die interconnect embodiments. FIG. 23A-23C, 24A-24C, 25A-25C, and 26A-26C illustrate plan and orthogonal cross-sectional views of an IC structure evolving as methods 2201 are practiced in accordance with some embodiments. However, methods 2201 (FIG. 22) may also be practiced to similarly fabricate lines of two different levels or heights.

Methods 2201 begin at input 2210 with receipt of a workpiece having a dielectric thin film over a working surface. At block 2215, a positive tone resist is applied over the workpiece. The resist applied at block 215 may have any of the attributes described above in the context of methods 101 (FIG. 1A) including a sufficiently dose-dependent develop response to define at least three exposure/develop levels. The resist applied at block 215 may advantageously define at least four exposure/develop levels. At block 2230 (FIG. 22), the photoresist is exposed with a grayscale mask, such as any of those described above in the context of methods 101. The grayscale mask has three or more regions corresponding to different exposure intensities, and advantageously has four or more regions corresponding to different exposure intensities.

At block 2230, a first via (or line) region of the resist is exposed to a first (high) dose, a second via (or line) region of the resist is exposed to a second (lower) dose, and a field region of the resist is exposed to a third (null) dose. For embodiments where a photoresist supports four development levels, line (or via) regions of the resist may be further exposed with the same imaging process, for example at a fourth dose that is non-zero and somewhere between the second and third doses. However, if a photoresist supports only three development levels, non-self-aligned line regions may be defined with a subsequent lithography loop comprising a second exposure. Any suitable post-exposure bake may also be practiced at block 2230 as embodiments herein are not limited in this respect.

In the example illustrated in FIG. 23A, resist 220 is over an area of workpiece 200. In this example, resist 220 supports four developable exposures and has been exposed with a single imaging process according to a four-tone grayscale mask. Resist field regions 207 have received a null dose. Resist line regions 204, 206 have received a low, but non-zero, dose. Resist 220 further comprises first via regions 2202, which have received a medium dose and second via regions 202 that have received a high dose. For alternative embodiments where resist 220 supports only three developable exposures, the "low" dose treatment can be excluded and only the two sets of via regions will be self-aligned. Although first and second via regions 2202 and 202 are illustrated, first and second line regions may be similarly copatterned in substantially the same manner.

FIG. 23B illustrates a cross-sectional view of workpiece 200 along the B-B' line illustrated in FIG. 23A. FIG. 23C illustrates a cross-sectional view of workpiece 200 along the C-C' line illustrated in FIG. 23A. As shown, resist 220 is over a workpiece thin film 205, which in exemplary embodiments comprises a dielectric material. The dielectric material may be any of those described above, for example comprising silicon and oxygen. Thin film 205 may also comprise multiple layers. Workpiece 200 further comprises a substrate 203, which may further comprise any number of thin film layers and crystalline semiconductor device layers over a handling/support material (e.g., monocrystalline silicon, etc.).

Returning to FIG. 22, methods 2201 continue at block 2240 where a first develop process removes a first via (line) region of the resist that received the highest dose exposure at block 2230. Methods 2201 continue at block 2250 where a first etch process, as masked by the retained photoresist, transfers first via regions into the workpiece by removing at least a portion of thin film material. Any etch process suitable for the composition of the thin film material may be practiced at block 2250 as embodiments herein are not limited in this respect.

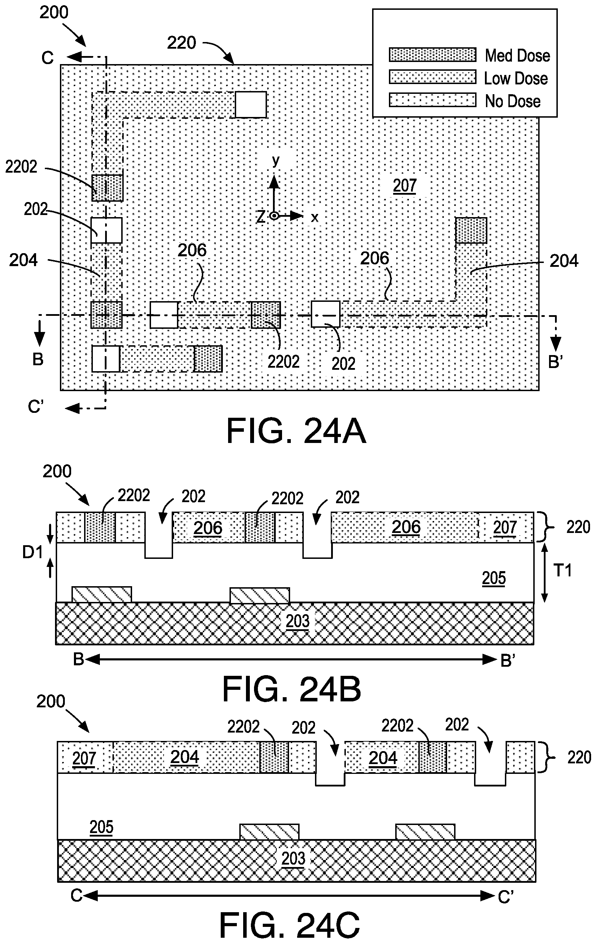

In the example illustrated in FIG. 24A, a partial thickness of underlying thin film 205 remains in via regions 202, for example following a fluorocarbon-based plasma etch process suitable for a silicon-based dielectric material. As further illustrated in FIG. 24B and 24C, via regions 202 extend into thin film 205 by a thickness or depth D1. In exemplary embodiments, depth D1 is less than the full thickness T1 of thin film 205. Undeveloped via regions 2202, as well as line regions 204, 206, are unetched by the first via etch process.

Returning to FIG. 22, methods 2201 continue at block 2260 where a second develop process dissolves second via (line) regions of the resist. In some embodiments, the second develop process is different than the first develop process performed at block 2240. In other embodiments, the second develop process is the same as the first develop process and the cumulative effect of the additional develop time clears resist regions that received a lower non-zero dose than the first via region, which developed in a first pass.

At block 2270 a second first etch process as masked by the retained photoresist defines second via regions with the workpiece by removing at least a portion of thin film material. For embodiments where the process performed at block 2250 etches only partially through the thin film material, the first via region is deepened at block 2270 concurrently with the etch of the second via region. Any etch process suitable for the composition of the thin film material may be practiced at block 2270 as embodiments herein are not limited in this respect. In some examples, the same etch process practiced at block 2250 is practiced at block 2270.

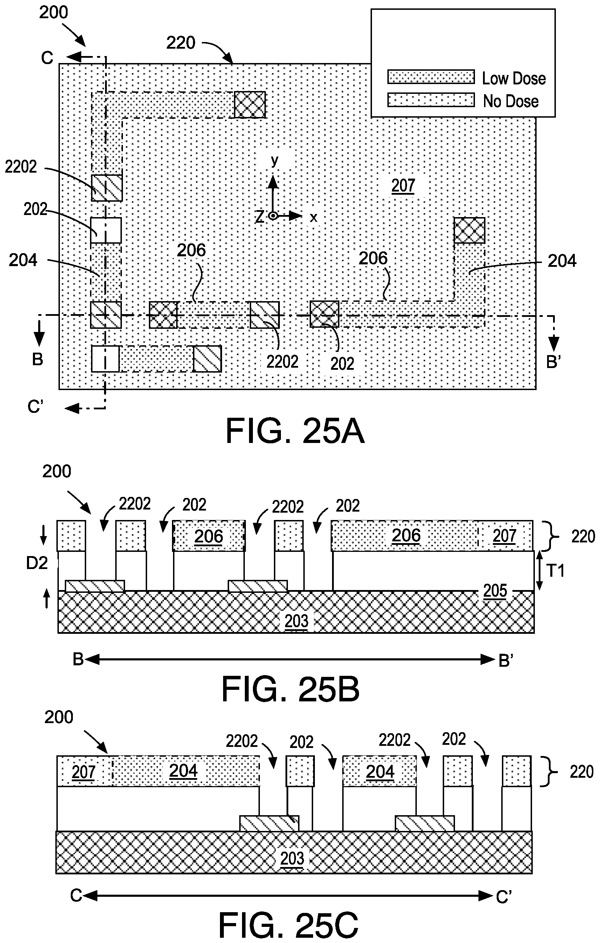

In the example illustrated in FIG. 25A, underlying substrate material 203 is exposed within via regions 202 and an intervening metallization is exposed within via regions 2202, for example following a fluorocarbon-based plasma etch process suitable for a silicon-based dielectric material. As further illustrated in FIG. 25B and 25C, via regions 2202 extend into thin film 205 by a thickness or depth D2 while via regions 202 extend into thin film 205 the full thickness T1 so that substrate 203 is exposed within via regions 202. Field region 207 and line regions 204, 206 retain thin film thickness T1. Notably, via regions 202 may be considered either deep via regions or a stack of via regions that a first width in the first dimension and a second width in the second dimension defined by pairs of opposite sidewalls within no misalignment over the thin film thickness T1.

Returning to FIG. 22, methods 2201 continue where any remaining resist having one or more regions of lower exposure (e.g., field regions having no exposure) are removed. For embodiments with four develop levels, another develop process may be performed followed by another thin film etch and/or selective film deposition (e.g., to define self-aligned line regions). Any resist remaining after a final pattern transfer may be stripped at block 2275. Methods 2201 then complete at block 2280 where a conductive material (e.g., metallization) is formed within the self-aligned via regions of different heights/depths (or lines of different heights/depths).

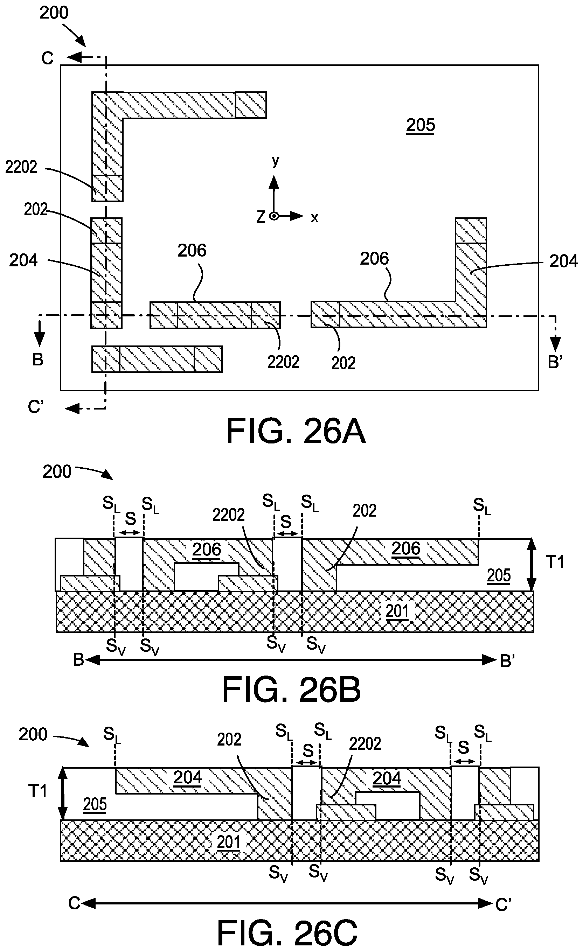

FIG. 26A-216C further illustrate workpiece 200 following metallization of the two via regions and line regions. In exemplary embodiments, the metallization comprises predominantly copper. Other conductive materials are also possible. Although not illustrated, interconnect metallization may comprise any of an adhesion layer, a barrier layer, and a fill material. As shown, via regions 202 have no misalignment to via regions 2202. Both via regions 202, 2202 also have no misalignment to line regions 204, 206 for embodiments where the lines are patterned with a fourth resist exposure and development level.

For embodiments with only three exposure and development levels necessitating separate patterning of line regions 204 and 206, via regions 202 and 2202 will have identical misalignment with first line regions 204 extending in a first dimension (e.g., y-dimension) and identical misalignment to second line regions 206 extending in a second dimension (e.g., x-dimension). Accordingly, sidewalls of a via region 202 of the interconnect metallization may be discontinuous with sidewalls of a line region of the interconnect metallization, but will have the same lateral offset or shift between sidewalls of the via and line regions as the via regions 2202.

In FIG. 26B, a via region 202 in direct contact with a line region 204 has a pair of opposite via sidewalls Sv that have no misalignment or lateral shift in the x-dimension from the pair of opposite line sidewalls S_{L} defining the transverse line width. For line region 204 there is no discontinuity between via sidewalls Sv and line sidewalls S_{L} within the x-dimension, which indicates line region 204 was patterned concurrently with via region 202. A width of via region 202 is essentially the same as the transverse width of line region 204. As further illustrated in FIG. 21B, another via region 2202 of a different depth that via region 202 also has a via sidewall Sv with no misalignment or lateral shift within the x-dimension from a line sidewall S_{L} defining one longitudinal end of line region 204. Because both via regions 202 and 2202 are in exact alignment with the line end, two adjacent via regions 202, 2202 are separated by line space S. Notably, each of line sidewall S_{L} and via sidewall Sv may be tapered or sloped so that space S may vary with sidewall depth, but continuity between line sidewall S_{L} and via sidewall Sv is nevertheless maintained. The lack of any misalignment between via regions 202 and line regions 204, 206 therefore remains evident regardless of sidewall verticality.

As further shown in FIG. 26B, two via regions 202, 2202 of different depths that are in contact with opposite ends of line regions 206 together have a pair of outer sidewalls Sv that have no misalignment with corresponding line sidewalls S_{L}. Although via dimensions may vary across via regions of different depths, in some exemplary embodiments via regions 202 and 2202 in contact with opposite ends of line region 206 have the same width or critical dimension (CD).

As further shown in FIG. 26C, all line sidewalls S_{L} similarly have no misalignment with via sidewalls Sv within the orthogonal y-dimension. Hence, the line region 204 which has a pair of line sidewalls S_{L} with no misalignment to a first pair of via sidewalls Sv within the x-dimension also has another pair of sidewalls S_{L}, one of which has no misalignment to one of another pair of via sidewalls Sv in the y-dimension. The perfect alignment between via regions 202, 2202 and line regions 204, 206 may therefore be considered a two-dimensional (2D) self-alignment of two levels of interconnect features (e.g., vias or line) with a third level of interconnect features (e.g., lines or vias).

Although FIG. 26A-26C illustrate feature sidewall alignment within two orthogonal dimensions, the exact alignment illustrated is possible for any/all orientations within the x-y plane because an absence of any misalignment is a direct result of the concurrent imaging of line regions 204, 206 with the multiple via regions 202, 2202 rather than a result of some complex multi-patterning scheme capable of optimizing alignment only within one dimension.

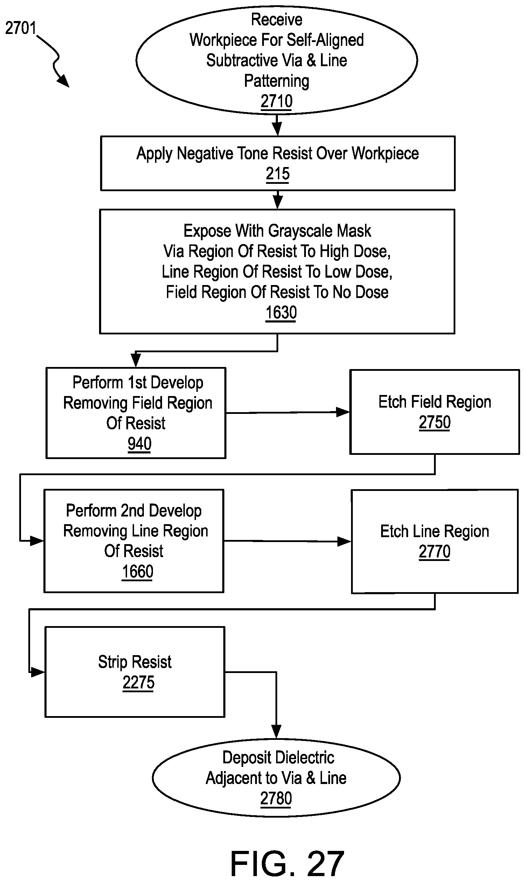

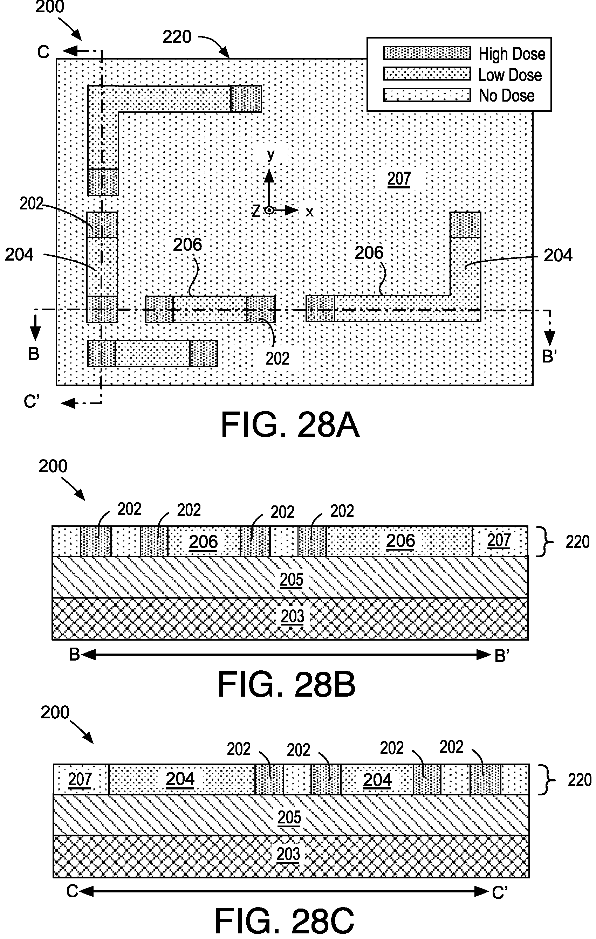

As an alternative to the damascene techniques described above, self-aligned via and line interconnect features may also be subtractively patterned based on tri-tone photoresist and grayscale patterning. FIG. 27 illustrates a flow diagram of methods 2701 for forming an IC with no misalignment between vias and lines, in accordance with some subtractive patterning embodiments. FIG. 28A-28C, 29A-29C, 30A-30C, and 31A-31C illustrate plan and orthogonal cross-sectional views of an IC structure evolving as methods 2701 (FIG. 27) are practiced in accordance with some embodiments.

Methods 2701 begin at input 2710 with receipt of a workpiece having an electrically conductive thin film (e.g., metallization, graphene, etc.) over a working surface. Interconnect structures comprising a level of vias above a level of lines are to be fabricated into the conductive thin film. At block 215, a negative tone resist is applied over the workpiece. The resist applied at block 215 may have any of the attributes described above in the context of methods 101 (FIG. 1A) including a sufficiently dose-dependent develop response to define three exposure/develop levels. At block 1630 (FIG. 27), the photoresist is exposed with a grayscale mask, such as any of those described above in the context of methods 101. A via region of the resist is exposed to a first (high) dose, a line region of the resist is exposed to a second (low) dose, and a field region of the resist is exposed to a third (null) dose. Any suitable post-exposure bake may be performed as embodiments herein are not limited in this respect.

In the example illustrated in FIG. 28A, resist 220 is over an area of a workpiece 200. Resist 220 has been exposed with a single imaging process according to a grayscale mask. Resist field regions 207 have received a null dose. Resist line regions 204, 206 have received a low, but non-zero, dose. Resist 220 further comprises via regions 202, which have received a high dose.

FIG. 28B illustrates a cross-sectional view of workpiece 200 along the B-B' line illustrated in FIG. 28A. FIG. 28C illustrates a cross-sectional view of workpiece 200 along the C-C' line illustrated in FIG. 28A. As shown, resist 220 is over a workpiece thin film 205, which in exemplary embodiments is an electrically conductive material. The conductive material may be predominantly a metal such as copper, or may be predominantly another metal, other than copper. In some advantageous embodiments, thin film 205 is predominantly Ru, which has good electrical conductivity and has better etch characteristics than Cu. In some other embodiments, thin film 205 is predominantly Ti, Al, or W. Thin film 205 may also comprise multiple layers, for example including an adhesion layer and/or a diffusion barrier layer. Workpiece 200 further comprises a substrate 203, which may further comprise any number of thin film layers and crystalline semiconductor device layers over a handling/support material (e.g., monocrystalline silicon, etc.).

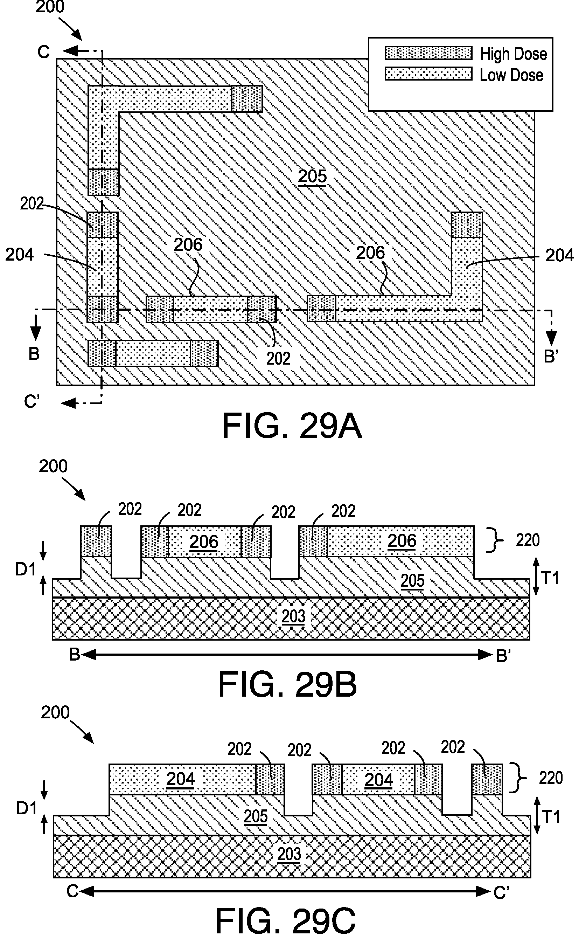

Returning to FIG. 27, methods 2701 continue at block 940 where a first develop process removes the field region of the resist that received no exposure (a null dose) at block 1630. Methods 2701 continue at block 2750 where the field region of the underlying conductive thin film is etched. Any etch process suitable for the composition of the conductive thin film may be practiced at block 2750 as embodiments are not limited in this respect. FIG. 29A-29C illustrate workpiece 200 following a first etch of thin film 205.

In the example illustrated in FIG. 29A, a partial thickness of underlying thin film 205 remains in field regions, for example following a halogen-based and/or fluorocarbon-based plasma etch process suitable for one or more metals. As further illustrated in FIG. 29B and 29C, thin film 205 is reduced in thickness by an etch depth D1. In exemplary embodiments, depth D1 is less than the full thickness T1 of thin film 205. Undeveloped line regions 204, 206 and via regions 202 are unetched by the etch process.

Methods 2701 (FIG. 27) continue at block 1660 where a second develop process is performed, which removes the line region of the resist that received a non-zero exposure (low) dose at block 1630. In some embodiments, the second develop process is different than the first develop process performed at block 940. In other embodiments, the second develop process is the same as the first develop process and the cumulative effect of the additional develop time clears resist regions that received a greater dose than the field region, which developed in a first pass. At block 2770 the line region of the underlying conductive thin film is etched, distinguishing line regions from via regions that remain protected by undeveloped photoresist. Any etch process suitable for the composition of the conductive thin film may be practiced at block 2750 as embodiments are not limited in this respect. In some examples, the same etch process performed at block 2750 is repeated at block 2770.

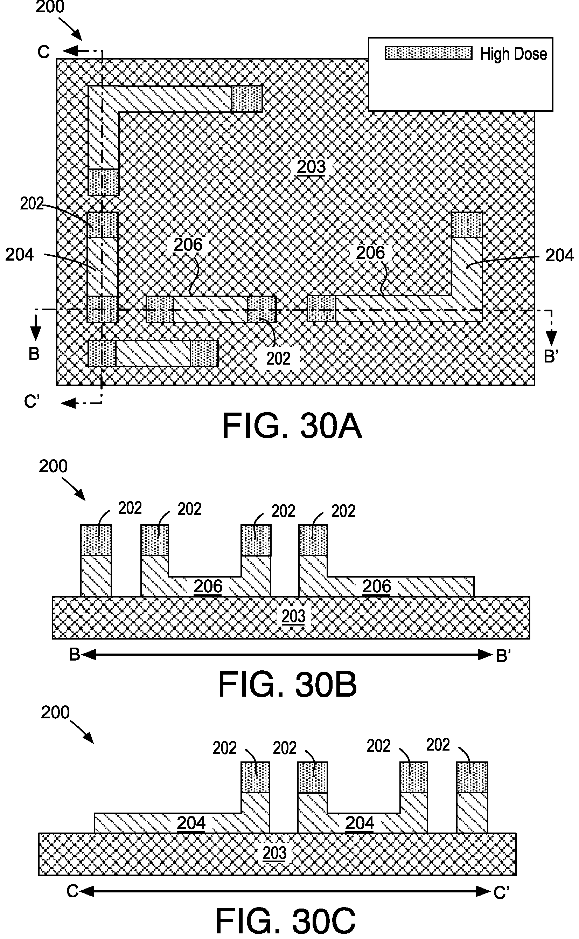

FIG. 30A-30C illustrate workpiece 200 following a second etch of thin film 205, which clears field regions of conductive material thereby defining line and via regions while concurrently thinning line regions 204, 206 relative to via regions 2202.

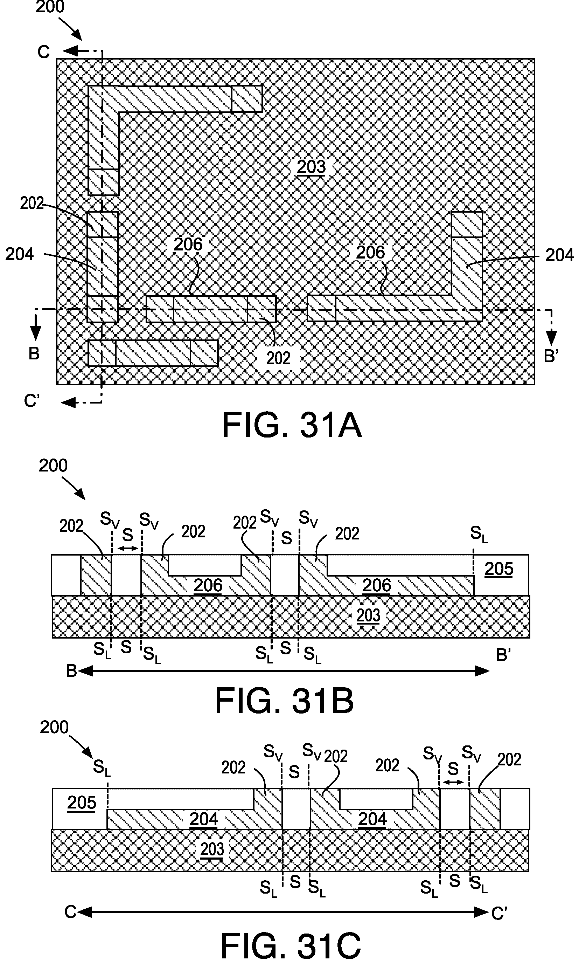

Following a resist strip at block 2275 (FIG. 27), methods 2701 complete at output 2780 where a dielectric material is formed over, and adjacent to sidewalls of, the via and line regions of the interconnect structures. A planarization process may level the working surface of the IC to enable additional iterations of methods 2701 in the fabrication of a stack of any number of interconnect structures. The interconnect structures illustrated in FIG. 31A-31C are analogs to the interconnect structures illustrated in FIG. 8A-8C, 15A-15C, 21A-21C, and 26A-26C. In FIG. 31A-31C, however, via regions 202 are over (rather than under) line regions 204, 206.

As shown in FIG. 31B-31C, via regions 202 have no misalignment both with first line regions 204 extending in a first dimension (e.g., y-dimension) and second line regions 206 extending in a second dimension (e.g., x-dimension). As described above, "no misalignment" means that sidewalls of a via region of the interconnect metallization are continuous with sidewalls of a line region of the interconnect metallization and there is no lateral offset, shift or other discontinuity between sidewalls of the via and line regions. Notably, and in accordance with embodiments herein, there is exact alignment within the x-y plane of the workpiece such that via sidewalls are precisely aligned with line sidewalls within both the x-dimension (as illustrated in FIG. 30B) and the y-dimension (as illustrated in FIG. 30C).

In FIG. 31B, a via region 202 in direct contact with a line region 204 has a pair of opposite via sidewalls Sv that have no misalignment or lateral shift in the x-dimension from the pair of opposite line sidewalls S_{L} defining the transverse line width. Hence, for line region 204 there is no discontinuity between via sidewalls Sv and line sidewalls S_{L} within the x-dimension. A width of via region 202 is therefore essentially the same as the transverse width of line region 204. As further illustrated in FIG. 31B, another via region 202 in contact with orthogonal line region 206 also has a via sidewall Sv with no misalignment or lateral shift within the x-dimension from a line sidewall S_{L} defining one longitudinal end of line region 204. Accordingly, a space S between adjacent line regions can be minimized for greater line density as line regions 204, 206 do not require a layout that includes a non-zero overlap of via regions 202. Because via regions 202 are in exact alignment with the line end and width sidewall, two adjacent via regions 202 are similarly separated by space S. Notably, each of line sidewall S_{L} and via sidewall Sv may be tapered or sloped so that space S may vary with sidewall depth, but continuity between line sidewall S_{L} and via sidewall Sv is nevertheless maintained. An absence of any misalignment between via regions 202 and line regions 204, 206 therefore remains evident regardless of sidewall verticality.

As further shown in FIG. 31C, all line sidewalls S_{L} similarly have no misalignment with via sidewalls Sv within the orthogonal y-dimension. Hence, the line region 204 which has a pair of line sidewalls S_{L} with no misalignment to a first pair of via sidewalls Sv within the x-dimension also has another pair of sidewalls S_{L}, one of which has no misalignment with one of another pair of via sidewalls Sv in the y-dimension. Likewise, the line region 206 which has a pair of line sidewalls S_{L} without any misalignment to a first pair of via sidewalls Sv within the y-dimension also has another pair of sidewalls S_{L}, one of which has no misalignment to one of another pair of via sidewalls Sv in the x-dimension. The perfect alignment between via regions 202 and line regions 204, 206 may therefore be considered a two-dimensional (2D) self-alignment of a first level of interconnect features (e.g., lines or vias) with a second level of interconnect features (e.g., vias or lines).

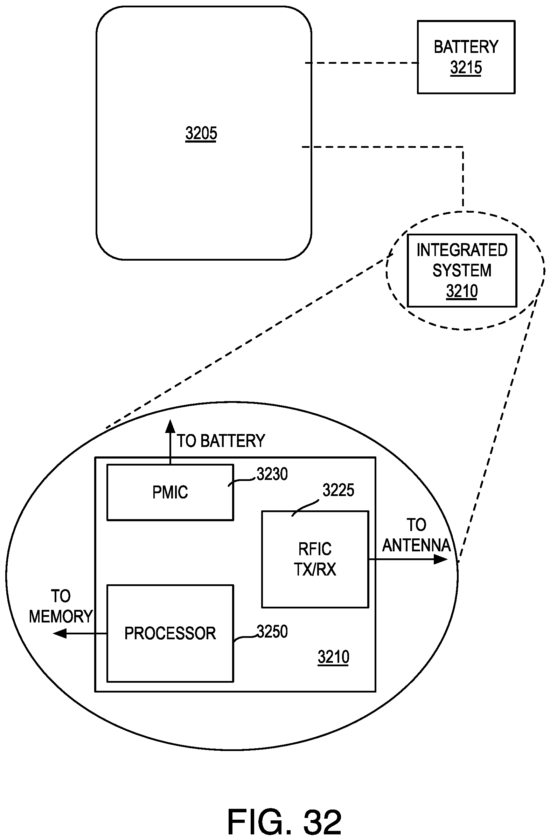

The IC interconnect structures and their techniques of fabrication described above may be incorporated into any IC. That IC may then be further incorporated into any IC package, which can be incorporated into any computing platform. FIG. 32 illustrates a computing platform 3205. Computing platform 3205 may be any commercial server, for example including any number of high-performance computing platforms within a rack and networked together for electronic data processing. Computing platform 3205 may include an integrated or disintegrated IC die system 3210, and a battery 3215.

As illustrated in the expanded view, IC die system 3210 is coupled to one or more of a power management integrated circuit (PMIC) 3230 or RF (wireless) integrated circuit (RFIC) 3225 including a wideband RF (wireless) transmitter and/or receiver. PMIC 3230 may perform battery power regulation, DC-to-DC conversion, etc., and has an input coupled to battery 3215 and with an output providing a current supply to other functional modules. In some embodiments processor 3250 includes IC interconnect structures with no misalignment between via and line regions, for example as described elsewhere herein. As further illustrated, in the exemplary embodiment, an RFIC 3225 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, and beyond.

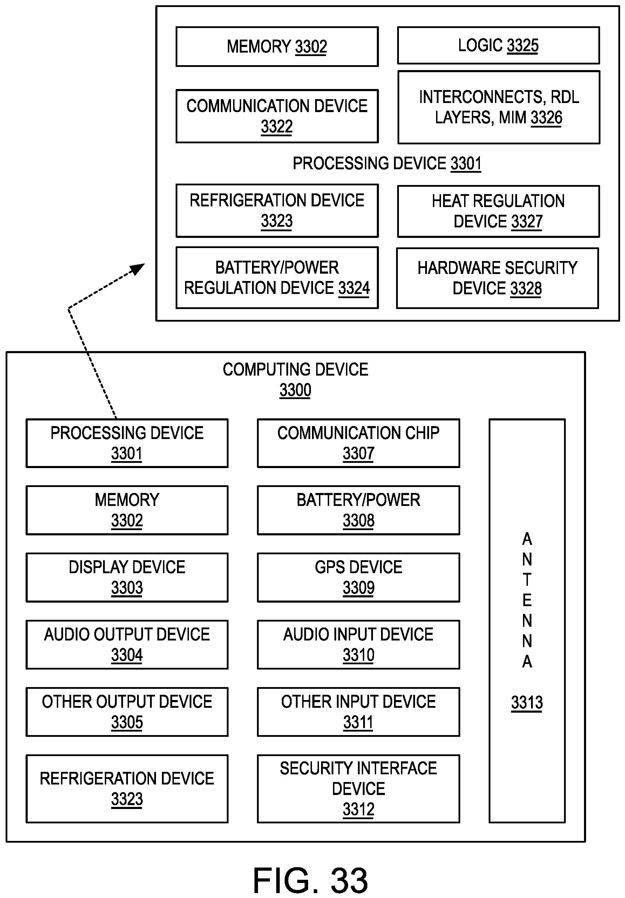

FIG. 33 is a block diagram of a cryogenically cooled computing device 3300 in accordance with some embodiments. For example, one or more components of computing device 3300 may include any of the devices or structures discussed elsewhere herein. Several components are illustrated in FIG. 33, but any one or more of these components may be omitted or duplicated, as suitable for the application. In some embodiments, some or all the components included in computing device 3300 may be attached to one or more printed circuit boards (e.g., a motherboard). In some embodiments, various ones of these components may be fabricated onto a single system-on-a-chip (SoC) die. Additionally, in various embodiments, computing device 3300 may not include one or more of the components illustrated in FIG. 33, but computing device 3300 may include interface circuitry for coupling to the one or more components. For example, computing device 3300 may not include a display device 3303, but may include display device interface circuitry (e.g., a connector and driver circuitry) to which display device 3303 may be coupled.

Computing device 3300 may include a processing device 3301 (e.g., one or more processing devices). As used herein, the term processing device or processor indicates a device that processes electronic data from registers and/or memory to transform that electronic data into other electronic data that may be stored in registers and/or memory. Processing device 3301 may include a memory 3302, a communication device 3322, a refrigeration/active cooling device 3323, a battery/power regulation device 3324, logic 3325, interconnects 3326, a heat regulation device 3327, and a hardware security device 3328.

Processing device 3301 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 3301 may include a memory 3302, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 3302 includes memory that shares a die with processing device 3301. This memory may be used as cache memory and may include embedded dynamic random-access memory (eDRAM) or spin transfer torque magnetic random-access memory (STT-M RAM).

Computing device 3300 may include a heat regulation/refrigeration device 3323. Heat regulation/refrigeration device 3323 may maintain processing device 3301 (and/or other components of computing device 3300) at a predetermined low temperature during operation. This predetermined low temperature may be any temperature discussed elsewhere herein.

In some embodiments, computing device 3300 may include a communication chip 3307 (e.g., one or more communication chips). For example, the communication chip 3307 may be configured for managing wireless communications for the transfer of data to and from computing device 3300. The term "wireless" and its derivatives may be used to describe circuits, devices, systems, methods, techniques, communications channels, etc., that may communicate data through the use of modulated electromagnetic radiation through a nonsolid medium.

Communication chip 3307 may implement any wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 3307 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 3307 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 3307 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 3307 may operate in accordance with other wireless protocols in other embodiments. Computing device 3300 may include an antenna 3313 to facilitate wireless communications and/or to receive other wireless communications (such as AM or FM radio transmissions).

In some embodiments, communication chip 3307 may manage wired communications, such as electrical, optical, or any other suitable communication protocols (e.g., the Ethernet). As noted above, communication chip 3307 may include multiple communication chips. For instance, a first communication chip 3307 may be dedicated to shorter-range wireless communications such as Wi-Fi or Bluetooth, and a second communication chip 3307 may be dedicated to longer-range wireless communications such as GPS, EDGE, GPRS, CDMA, WiMAX, LTE, EV-DO, or others. In some embodiments, a first communication chip 3307 may be dedicated to wireless communications, and a second communication chip 3307 may be dedicated to wired communications.

Computing device 3300 may include battery/power circuitry 3308. Battery/power circuitry 3308 may include one or more energy storage devices (e.g., batteries or capacitors) and/or circuitry for coupling components of computing device 3300 to an energy source separate from computing device 3300 (e.g., AC line power).

Computing device 3300 may include a display device 3303 (or corresponding interface circuitry, as discussed above). Display device 3303 may include any visual indicators, such as a heads-up display, a computer monitor, a projector, a touchscreen display, a liquid crystal display (LCD), a light-emitting diode display, or a flat panel display, for example.

Computing device 3300 may include an audio output device 3304 (or corresponding interface circuitry, as discussed above). Audio output device 3304 may include any device that generates an audible indicator, such as speakers, headsets, or earbuds, for example.

Computing device 3300 may include an audio input device 3310 (or corresponding interface circuitry, as discussed above). Audio input device 3310 may include any device that generates a signal representative of a sound, such as microphones, microphone arrays, or digital instruments (e.g., instruments having a musical instrument digital interface (MIDI) output).

Computing device 3300 may include a global positioning system (GPS) device 3309 (or corresponding interface circuitry, as discussed above). GPS device 3309 may be in communication with a satellite-based system and may receive a location of computing device 3300, as known in the art.

Computing device 3300 may include another output device 3305 (or corresponding interface circuitry, as discussed above). Examples include an audio codec, a video codec, a printer, a wired or wireless transmitter for providing information to other devices, or an additional storage device.

Computing device 3300 may include another input device 3311 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 3300 may include a security interface device 3312. Security interface device 3312 may include any device that provides security measures for computing device 3300 such as intrusion detection, biometric validation, security encode or decode, managing access lists, malware detection, or spyware detection.

Computing device 3300, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that practice of the disclosed techniques and architectures is not limited to the embodiments so described but can be modified and altered without departing from the scope of the appended claims. For example, the above embodiments may include specific combinations of features as further provided below.

In first examples, an integrated circuit (IC) structure comprises a first feature within a first level of the IC structure, the first feature having a first pair of opposite sidewalls within a first dimension, and a second pair of opposite sidewalls within a second dimension, orthogonal to the first dimension. The IC structure comprises a second feature within a second level of the IC structure and in direct contact with the first feature. The second feature comprises a third pair of opposite sidewalls within the first dimension and having no misalignment to the first pair of opposite sidewalls, and a fourth pair of opposite sidewalls within the second dimension. At least one of the fourth pair of opposite sidewalls has no misalignment to at least one of the second pair of opposite sidewalls.

In second examples, for any of the first examples the first feature is a line having a transverse width in the first dimension and a longitudinal length in the second dimension, the longitudinal length extending between two opposite line ends and at least two times larger the transverse width of the line. The second feature is a via comprising a width in the first dimension that is equal to the transverse width of the line, and wherein a sidewall of the via has no misalignment from a sidewall of a first of the opposite line ends.

In third examples, for any of the second examples the IC structure further comprises a second via coplanar with the via. The second via has the width in the first dimension and has no misalignment from a sidewall of a second of the opposite line ends.

In fourth examples, for any of the third examples the IC structure further comprises a second line with a longitudinal length in the second dimension, the second line comprising a third line end proximal to a first of the line ends and a second line end distal from the first of the line ends. The IC structure further comprises a second via coplanar with the via. The second via has no misalignment from a sidewall from the second line end.

In fifth examples, for any of the first through fourth examples the first feature comprises, a line having a longitudinal length including a first segment extending in the first dimension and a second segment extending in the second dimension. The first segment has a first transverse width in the second dimension and the second segment has a second transverse width in the first dimension.

In sixth examples, for any of the fifth examples the second feature is a via comprising a width that is equal to the first transverse width, and wherein a sidewall of the via has no misalignment from a sidewall of an end of the first segment.

In seventh examples, an apparatus comprises an integrated circuit (IC) interconnect line. The line comprises a first line segment that intersects a second, non-parallel line segment. The apparatus comprises a first IC interconnect via over or below the IC interconnect line. The first IC interconnect via is in direct contact with the first segment of IC interconnect line. The via comprises sidewalls within a first dimension of the IC that have no misalignment with sidewalls of the first segment. The apparatus comprises a second IC interconnect via over or below the IC interconnect line. The second IC interconnect via is in direct contact with the second segment of IC interconnect line. The via comprises sidewalls within a second dimension of the IC that have no misalignment with sidewalls of the second segment.

In eighth examples, for any of the seventh examples the first IC interconnect via is coplanar with the second IC interconnect via.

In ninth examples, for any of the eighth examples the first IC interconnect via comprises a sidewall having no misalignment with an end of the first IC interconnect line segment.

In tenth examples, a method comprises receiving an integrated circuit (IC) workpiece comprising a thin film. The method comprises applying a resist over the thin film and exposing at least two regions of the resist with different non-zero doses imaged through a single mask. The method comprises developing a first resist feature associated with a first of the non-zero doses and transferring the first resist feature into an underlying film of the IC workpiece. The method comprises developing a second resist feature associated with a second of the non-zero exposure doses, and transferring the second resist feature into the thin film.

In eleventh examples, for any of the tenth examples the resist has a dose dependent develop response.

In twelfth examples, for any of the tenth through eleventh examples the resist comprises a metal oxide and wherein the exposing comprises imaging EUV radiation reflected by the mask.

In thirteenth examples, for any of the tenth through eleventh examples the resist comprises a chemical amplified resist (CAR) and wherein the exposing comprises imaging DUV radiation through the mask.

In fourteenth examples, for any of the tenth through thirteenth examples the mask comprises absorbers of a first height associated with the first feature, and wherein the mask comprises absorbers of a second height, different than the first, associated with a second feature.

In fifteenth examples, for any of the tenth through fourteenth examples the mask comprises absorbers of a first spatial density associated with a first feature, and wherein the mask comprises absorbers of a second spatial density, different than the first, associated with the second feature.

In sixteen examples for any of the tenth through fifteenth examples the thin film comprises a dielectric material. Applying the resist comprises applying a negative tone resist. Exposing the at least two regions of the resist comprises exposing a field region of the resist to a high dose, a line region of the resist to a low dose, and a via region of the resist to no dose. Developing the first resist feature comprises removing the via region of the resist. Transferring the first resist feature into the thin film comprises etching a via into the dielectric material, developing the second resist feature comprises removing the line region of the resist. Transferring the second resist feature into the thin film comprises etching a line into the dielectric material.

In seventeenth examples, for any of the tenth through fifteenth examples the thin film comprises a dielectric material. Applying the resist comprises applying a negative tone resist, exposing the at least two regions of the resist comprises exposing a line region of the resist to a high dose, a via region of the resist to a low dose, and a field region of the resist to no dose. Developing the first resist feature comprises removing the via region of the resist. Developing the second resist feature comprise removing the line region of the resist. Transferring the first and second resist features into the thin film comprises selectively depositing a material within the field region. Etching a via into the dielectric material a first depth after developing the first resist feature and before developing the second resist feature. Etching a via into the dielectric material to a second depth while etching the line into the dielectric after developing the second resist feature.

In eighteenth examples, for any of the tenth examples the thin film comprises a dielectric material. Applying the resist comprises applying a positive tone resist. Exposing the at least two regions of the resist comprises exposing a via region of the resist to a high dose, a line region of the resist to a low dose, and a field region of the resist to no dose. Developing the first resist feature comprises removing the line region of the resist. Developing the second resist feature comprises removing the via region of the resist. Transferring the first and second resist features into the thin film comprises selectively depositing a material within the field region after removing the field region of the resist and before developing the first resist feature, selectively depositing a material within the field region and the line region after removing the line region of the resist and before removing the via region of the resist, etching a via into a dielectric material to a first depth after removing the via region of the resist ,etching a line into the dielectric material after removing the material deposited within the line region while further etching the via to a second depth.

In nineteenth examples, for any of the tenth examples the thin film comprises a dielectric material. Applying the resist comprises applying a negative tone resist. Exposing the at least two regions of the resist comprises exposing a first via or line region of the resist to a high dose, a second via or line region of the resist to a low dose, and a field region of the resist to no dose. Developing the first resist feature comprises removing the first via or line region of the resist. Transferring the first resist feature into the thin film comprises etching a first via or line into the dielectric material to a first depth. Developing the second resist feature comprises removing the second via or line region of the resist. Transferring the second resist feature into the thin film comprises etching a second via or line into the dielectric material to the first depth while further etching the first via or line to a second depth.

In twentieth examples, for any of the tenth examples the thin film comprises a metal. Applying the resist comprises applying a negative tone resist. Exposing the at least two regions of the resist comprises exposing a via region of the resist to a high dose, a line region of the resist to a low dose, and a field region of the resist to no dose. Developing the first resist feature comprises removing the line region of the resist. Developing the second resist feature comprises removing the via region of the resist. Transferring the first and a second resist feature into the thin film comprises etching at least a partial thickness of an exposed portion of the metal after removing the field region and before removing the line or via regions of the resist, and etching partially through the metal after removing the line region and before removing the via region of the resist.

However, the above embodiments are not limited in this regard, and, in various implementations, the above embodiments may include the undertaking of only a subset of such features, undertaking a different order of such features, undertaking a different combination of such features, and/or undertaking additional features than those features explicitly listed. The scope of the disclosed techniques and architectures should therefore be determined with reference to the appended claims, along with the full scope of equivalents to which such claims are entitled.

## Claims

1. An integrated circuit (IC) structure, comprising:
a first feature within a first level of the IC structure, the first feature having a first pair of opposite sidewalls within a first dimension, and a second pair of opposite sidewalls within a second dimension, orthogonal to the first dimension;
a second feature within a second level of the IC structure and in direct contact with the first feature, wherein the second feature comprises:
a third pair of opposite sidewalls within the first dimension and having no misalignment from the first pair of opposite sidewalls; and
a fourth pair of opposite sidewalls within the second dimension, wherein at least one of the fourth pair of opposite sidewalls has no misalignment with at least one of the second pair of opposite sidewalls.

2. The IC structure of claim 1, wherein:
the first feature is a line having a transverse width in the first dimension and a longitudinal length in the second dimension, the longitudinal length extending between two opposite line ends and at least two times larger the transverse width of the line;
the second feature is a via comprising a width in the first dimension that is equal to the transverse width of the line, and wherein a sidewall of the via has no misalignment from a sidewall of a first of the opposite line ends.

3. The IC structure of claim 2, further comprising a second via coplanar with the via, wherein the second via has the width in the first dimension and has no misalignment from a sidewall of a second of the opposite line ends.

4. The IC structure of claim 2, further comprising:
a second line with a longitudinal length in the second dimension, the second line comprising a third line end proximal to a first of the line ends and a second line end distal from the first of the line ends; and
a second via coplanar with the via, wherein the second via has no misalignment from a sidewall from the second line end.

5. The IC structure of claim 1, wherein the first feature comprises:
a line having a longitudinal length including a first segment extending in the first dimension and a second segment extending in the second dimension; and
wherein the first segment has a first transverse width in the second dimension and the second segment has a second transverse width in the first dimension.

6. The IC structure of claim 5, wherein the second feature is a via comprising a width that is equal to the first transverse width, and wherein a sidewall of the via has no misalignment from a sidewall of an end of the first segment.

7. A method comprising:
receiving an integrated circuit (IC) workpiece comprising a thin film;
applying a resist over the thin film;
exposing at least two regions of the resist with different non-zero doses imaged through a single mask;
developing a first resist feature associated with a first of the non-zero doses;
transferring the first resist feature into an underlying film of the IC workpiece;
developing a second resist feature associated with a second of the non-zero exposure doses; and
transferring the second resist feature into the thin film.

8. The method of claim 7, wherein the resist has a dose dependent develop response.

9. The method of claim 8, wherein the resist comprises a metal oxide and the exposing comprises imaging EUV radiation reflected by the mask, or wherein the resist comprises a chemical amplified resist (CAR) and the exposing comprises imaging DUV radiation through the mask.

10. The method of any one of claims 7-8, wherein the mask comprises absorbers of a first height or a first spatial density associated with the first feature, and wherein the mask comprises absorbers of a second height or second spatial density, different than the first, associated with a second feature.

11. The method of any one of claims 7-10, wherein:
the thin film comprises a dielectric material;
applying the resist comprises applying a negative tone resist;
exposing the at least two regions of the resist comprises exposing a field region of the resist to a high dose, a line region of the resist to a low dose, and a via region of the resist to no dose;
developing the first resist feature comprises removing the via region of the resist;
transferring the first resist feature into the thin film comprises etching a via into the dielectric material;
developing the second resist feature comprises removing the line region of the resist; and
transferring the second resist feature into the thin film comprises etching a line into the dielectric material.

12. The method of any one of claims 7-10, wherein:
the thin film comprises a dielectric material;
applying the resist comprises applying a negative tone resist;
exposing the at least two regions of the resist comprises exposing a line region of the resist to a high dose, a via region of the resist to a low dose, and a field region of the resist to no dose;
developing the first resist feature comprises removing the via region of the resist;
developing the second resist feature comprise removing the line region of the resist; and
transferring the first and second resist features into the thin film comprises:
selectively depositing a material within the field region;
etching a via into the dielectric material a first depth after developing the first resist feature and before developing the second resist feature; and
etching a via into the dielectric material to a second depth while etching the line into the dielectric after developing the second resist feature.

13. The method of any one of claims 7-10, wherein:
the thin film comprises a dielectric material;
applying the resist comprises applying a positive tone resist;
exposing the at least two regions of the resist comprises exposing a via region of the resist to a high dose, a line region of the resist to a low dose, and a field region of the resist to no dose;
developing the first resist feature comprises removing the line region of the resist;
developing the second resist feature comprises removing the via region of the resist; and
transferring the first and second resist features into the thin film comprises:
selectively depositing a material within the field region after removing the field region of the resist and before developing the first resist feature;
selectively depositing a material within the field region and the line region after removing the line region of the resist and before removing the via region of the resist;
etching a via into a dielectric material to a first depth after removing the via region of the resist; and
etching a line into the dielectric material after removing the material deposited within the line region while further etching the via to a second depth.

14. The method of any one of claims 7-10, wherein:
the thin film comprises a dielectric material;
applying the resist comprises applying a negative tone resist;
exposing the at least two regions of the resist comprises exposing a first via or line region of the resist to a high dose, a second via or line region of the resist to a low dose, and a field region of the resist to no dose;
developing the first resist feature comprises removing the first via or line region of the resist;
transferring the first resist feature into the thin film comprises etching a first via or line into the dielectric material to a first depth;
developing the second resist feature comprises removing the second via or line region of the resist; and
transferring the second resist feature into the thin film comprises etching a second via or line into the dielectric material to the first depth while further etching the first via or line to a second depth.

15. The method of any one of claims 7-10, wherein:
the thin film comprises a metal;
applying the resist comprises applying a negative tone resist;
exposing the at least two regions of the resist comprises exposing a via region of the resist to a high dose, a line region of the resist to a low dose, and a field region of the resist to no dose;
developing the first resist feature comprises removing the line region of the resist;
developing the second resist feature comprises removing the via region of the resist; and
transferring the first and a second resist feature into the thin film comprises:
etching at least a partial thickness of an exposed portion of the metal after removing the field region and before removing the line or via regions of the resist; and
etching partially through the metal after removing the line region and before removing the via region of the resist.
